# EUROPEAN PATENT APPLICATION

(11) **EP 4 319 533 A2**
(43) Date of publication of application: **07.02.2024**
(21) Application number: 23185784.8
(22) Date of filing: 17.07.2023
(51) Int. Cl.: H10B 43/10, H10B 43/27, H10B 43/40, H10B 43/50, H10N 97/00

(54) **NONVOLATILE MEMORY DEVICES AND MEMORY SYSTEMS INCLUDING THE SAME**

(30) Priority: 02.08.2022 KR 20220096105
(71) Applicant: Samsung Electronics Co., Ltd., Suwon-si, Gyeonggi-do 16677 (KR)
(72) Inventor: KANG, Inho, 16677 Suwon-si (KR); KIM, Seungyeon, 16677 Suwon-si (KR); KIM, Jiyoung, 16677 Suwon-si (KR); YANG, Woosung, 16677 Suwon-si (KR); LEE, Jaeeun, 16677 Suwon-si (KR); SONG, Kiwhan, 16677 Suwon-si (KR)
(74) Representative: Marks & Clerk LLP

(57) **Abstract**

Nonvolatile memory devices and memory systems including the same are disclosed. A vertically-integrated nonvolatile memory device includes a peripheral circuit structure with a peripheral circuit therein, and cell array structure that is bonded to the peripheral circuit structure, and has a cell area and a connection area therein. The cell area includes a plurality of gate electrodes and a plurality of insulating layers alternately stacked, in the connection area. The plurality of gate electrodes include a cell stack having a staircase shape, a plurality of capacitor core contact structures configured to pass through the cell stack in the cell area, and a plurality of capacitor gate contact structures connected to the plurality of gate electrodes in the connection area. Each of the plurality of capacitor core contact structures includes: (i) a first core conductor electrically connected to the peripheral circuit, and (ii) a first cover insulating layer extending between the first core conductor and the plurality of gate electrodes, and constitutes a capacitor in which the first core conductor, the first cover insulating layer, and the plurality of gate electrodes are connected to the peripheral circuit.

## Description

### BACKGROUND

The inventive concept relates to nonvolatile memory devices and memory systems including the same. More particularly, the inventive concept relates to three-dimensional (3D) nonvolatile memory devices and memory systems including the same.

Consumers require nonvolatile memory devices having high performance, small size with higher integration, and low prices. To achieve high-integration nonvolatile memory devices, 3D nonvolatile memory devices, in which a plurality of memory cells are arranged in a vertical direction, have been suggested.

### SUMMARY

The inventive concept provides a nonvolatile memory device having higher operation reliability, and a memory system including the same.

According to an aspect of the inventive concept, there is provided a nonvolatile memory device, which includes a peripheral circuit structure having a peripheral circuit therein, and a cell array structure that is bonded to the peripheral circuit structure and includes a cell area and a connection area. The cell array structure includes a plurality of gate electrodes and a plurality of insulating layers alternately stacked, and in the connection area, the plurality of gate electrodes include a cell stack having a staircase shape, a plurality of capacitor core contact structures configured to pass through the cell stack in the cell area, and a plurality of capacitor gate contact structures connected to the plurality of gate electrodes in the connection area. Each of the plurality of capacitor core contact structures includes a first core conductor electrically connected to the peripheral circuit and a first cover insulating layer extending between the first core conductor and the plurality of gate electrodes, and constitutes a capacitor in which the first core conductor, the first cover insulating layer, and the plurality of gate electrodes are connected to the peripheral circuit. In some embodiments, at least a portion of the plurality of capacitor core contact structures overlaps the peripheral circuit electrically connected to the plurality of capacitor core contact structures in a vertical direction.

According to another aspect of the inventive concept, there is provided a nonvolatile memory device including a peripheral circuit structure having a peripheral circuit therein, and a cell array structure, which is bonded to the peripheral circuit structure and includes a main cell block and a dummy cell block, with each block including a cell area and a connection area. The cell array structure includes a plurality of gate electrodes and a plurality of insulating layers alternately stacked. In the connection area, the plurality of gate electrodes include a cell stack having a staircase shape, a plurality of cell channel structures configured to pass through the cell stack in the cell area of the cell block, a plurality of capacitor core contact structures configured to pass through the cell stack in the cell area of the dummy cell block, and a plurality of capacitor gate contact structures connected to the plurality of gate electrodes in the connection area of the dummy cell block. Each of the plurality of capacitor core contact structures includes a first core conductor electrically connected to the peripheral circuit and a first cover insulating layer located between the first core conductor and the plurality of gate electrodes, and constitutes a capacitor in which the first core conductor, the first cover insulating layer, and the plurality of gate electrodes are connected to the peripheral circuit.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of a nonvolatile memory device according to an embodiment;
FIG. 2 is a schematic perspective view of a nonvolatile memory device according to an embodiment;
FIG. 3 is an equivalent circuit diagram of a nonvolatile memory device according to an embodiment;
FIG. 4 is a schematic layout diagram of a nonvolatile memory device according to an embodiment;
FIG. 5A is a plan view of a nonvolatile memory device according to an embodiment;
FIGS. 5B and 5C are perspective views of a nonvolatile memory device of FIG. 5A;
FIG. 6 is a plan view of a nonvolatile memory device according to embodiments;
FIGS. 7A and 7B are cross-sectional views of a nonvolatile memory device according to embodiments;
FIGS. 8A through 8C are enlarged cross-sectional views illustrating a cell channel structure of a nonvolatile memory device according to embodiments;
FIGS. 9 and 10 are plan views of a nonvolatile memory device according to embodiments;
FIGS. 11A and 11B are cross-sectional views of a nonvolatile memory device according to embodiments;
FIGS. 12 and 13 are plan views of a nonvolatile memory device according to embodiments;
FIG. 14 is a view schematically illustrating a memory system of a nonvolatile memory device according to embodiments;
FIG. 15 is a perspective view schematically illustrating a memory system of a nonvolatile memory device according to embodiments; and
FIG. 16 is a cross-sectional view schematically illustrating a semiconductor package according to embodiments.

### DETAILED DESCRIPTION OF THE EMBODIMENTS

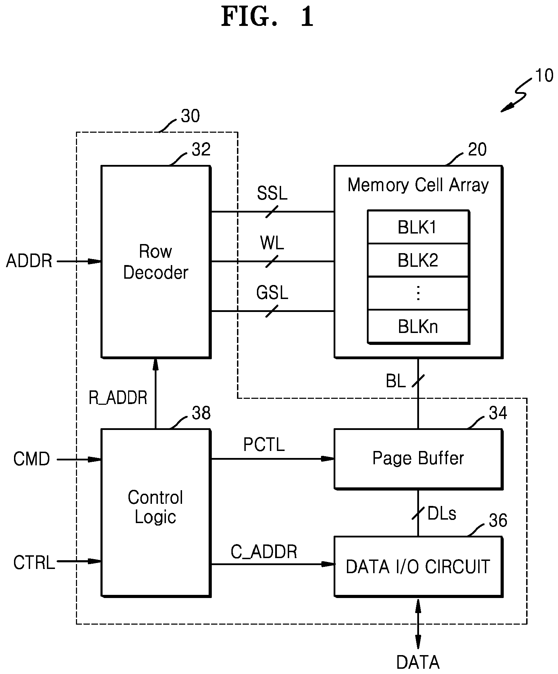

FIG. 1 is a block diagram of a nonvolatile memory device according to an embodiment. Referring to FIG. 1, a nonvolatile memory device 10 may include a memory cell array 20 and a peripheral circuit 30. The memory cell array 20 may include a plurality of memory cell blocks BLK1, BLK2, ... , and BLKn. Each of the plurality of memory cell blocks BLK1, BLK2, ..., and BLKn may include a plurality of memory cells. The memory cell bocks BLK1, BLK2, ..., and BLKn may be connected to the peripheral circuit 30 through a bit line BL, a word line WL, a string selection line SSL, and a ground selection line GSL.

The peripheral circuit 30 may include a row decoder 32, a page buffer 34, a data input/output (I/O) circuit 36, and a control logic 38. In some embodiments, the peripheral circuit 30 may further include an input/output interface, a column logic, a voltage generator, a predecoder, a temperature sensor, a command decoder, an address decoder, an amplification circuit, and the like.

The memory cell array 20 may be connected to the page buffer 34 through the bit line BL and the row decoder 32 through the word line WL, the string selection line SSL, and the ground selection line GSL. In the memory cell array 20, each of a plurality of memory cells included in the plurality of memory cell blocks BLK1, BLK2, ..., and BLKn may be a flash memory cell. The memory cell array 20 may include a three-dimensional (3D) memory cell array. The 3D memory cell array may include a plurality of NAND strings extending in a vertical direction, and each of the plurality of NAND strings may include a plurality of memory cells respectively connected to a plurality of word lines WL stacked on a substrate in the vertical direction.

The peripheral circuit 30 may receive an address ADDR, a command CMD, and a control signal CTRL from the outside of the nonvolatile memory device 10, and may transmit/receive data to/from a device disposed outside the nonvolatile memory device 10. The row decoder 32 may select at least one of the plurality of memory cell blocks BLK1, BLK2, ..., and BLKn in response to the address ADDR from the outside, and may select the word line WL, the string selection line SSL, and the ground selection line GSL of the selected memory cell block. The row decoder 32 may transmit a voltage for performing a memory operation to the word line WL of the selected memory cell block.

The page buffer 34 may be connected to the memory cell array 20 through the bit line BL. The page buffer 34 may operate as a write driver during a program operation to apply a voltage according to the data to be stored in the memory cell array 20 to the bit line BL, and may operate as a sensing amplifier during a read operation to sense the data stored in the memory cell array 20. The page buffer 34 may operate in response to a control signal PCTL supplied from the control logic 38.

The data I/O circuit 36 may be connected to the page buffer 34 through data lines DLs. The data I/O circuit 36 may receive the data from a memory controller (illustration omitted) during a program operation and may provide program data to the page buffer 34 based on a column address C_ADDR provided from the control logic 38. The data I/O circuit 36 may provide read data stored in the page buffer 34 to the memory controller based on the column address C_ADDR provided from the control logic 38 during a read operation.

The data I/O circuit 36 may transmit an input address or command to the control logic 38 or the row decoder 32. The peripheral circuit 30 may further include an electro-static discharge (ESD) circuit and a pull-up/pull-down driver. The control logic 38 may receive the command CMD and the control signal CTRL from the memory controller. The control logic 38 may provide a row address R_ADDR to the row decoder 32 and may provide the column address C_ADDR to the data I/O circuit 36. The control logic 38 may generate various internal control signals used in the nonvolatile memory device 10 in response to the control signal CTRL. For example, the control logic 38 may adjust a voltage level provided to the word line WL and the bit line BL when performing a memory operation, such as a program operation or an erase operation.

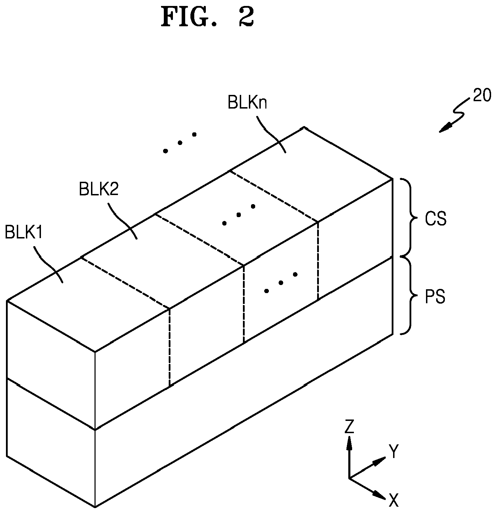

FIG. 2 is a schematic perspective view of the nonvolatile memory device according to an embodiment. Referring to FIG. 2, the nonvolatile memory device 10 may include a cell array structure CS and a peripheral circuit structure PS that overlap each other in a vertical direction (Z-direction). The cell array structure CS may include the memory cell array 20 described with reference to FIG. 1. The peripheral circuit structure PS may include the peripheral circuit 30 described with reference to FIG. 1.

The cell array structure CS may include a plurality of memory cell blocks BLK1, BLK2, ... , and BLKn. Each of the plurality of memory cell blocks BLK1, BLK2, ..., and BLKn may include a plurality of memory cells, which are arranged in a 3D manner.

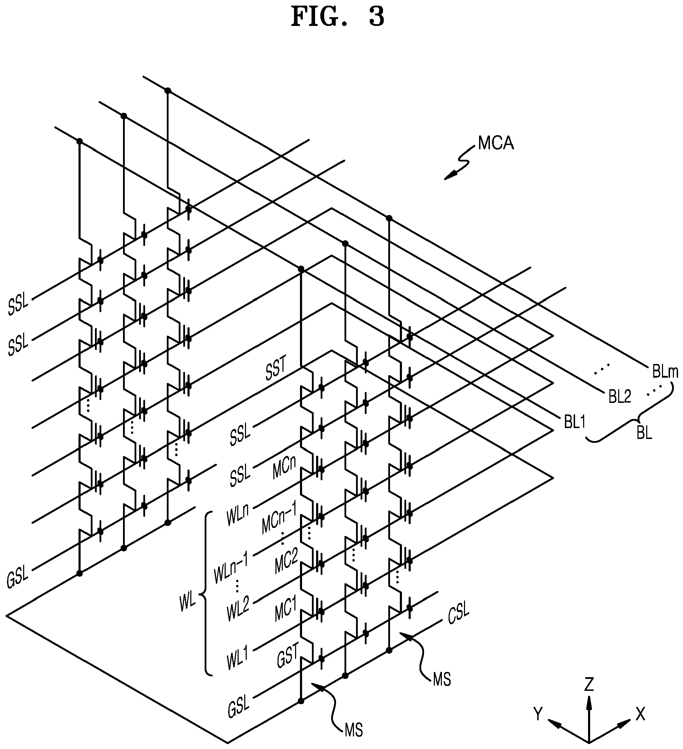

FIG. 3 is an equivalent circuit diagram of a nonvolatile memory device according to an embodiment. Referring to FIG. 3, a memory cell array MCA may include a plurality of memory cell strings MS. Each of the plurality of memory cell strings MS may extend in the vertical direction (Z-direction). The memory cell array MCA may include a plurality of word lines WL (WL1, WL2, ..., WLn-1, and WLn), a plurality of bit lines BL (BL1, BL2, ..., and BLm), at least one string selection line SSL, at least one ground selection line GSL, and a common source line CSL. Each of the plurality of word lines WL (WL1, WL2, ..., WLn-1, and WLn) may extend in a first horizontal direction (X-direction), and each of the plurality of bit lines BL (BL1, BL2, ..., and BLm) may extend in a second horizontal direction (Y-direction), which is orthogonal to the first horizontal direction (X-direction). Each of at least one string selection line SSL and at least one ground selection line GSL may extend in the same direction as a direction of the plurality of word lines WL (WL1, WL2, ..., WLn-1, and WLn), for example, the first horizontal direction (X-direction). A plurality of memory cell strings MS may be formed between the plurality of bit lines BL (BL1, BL2, ..., and BLm) and the common source line CSL. FIG. 3 illustrates that each of the plurality of memory cell strings MS includes two string selection lines SSL. However, the inventive concept is not limited thereto. For example, each of the memory cell strings MS may include one string selection line SSL.

Each of the plurality of memory cell strings MS may include a string selection transistor SST, a ground selection transistor GST, and a plurality of memory cell transistors MC1, MC2, ..., MCn-1, and MCn. A drain area of the string selection transistor SST may be connected to the bit lines BL (BL1, BL2, ..., and BLm), and a source area of the ground selection transistor GST may be connected to the common source line CSL. The common source line CSL may be an area to which source areas of the plurality of ground selection transistors GST are commonly connected.

The string selection transistor SST may be connected to the string selection line SSL, and the ground selection transistor GST may be connected to the ground selection line GSL. Each of the plurality of memory cell transistors MC1, MC2, ..., MCn-1, and MCn may be connected to its corresponding word line among the plurality of word lines WL (WL1, WL2, ..., WLn-1, and WLn).

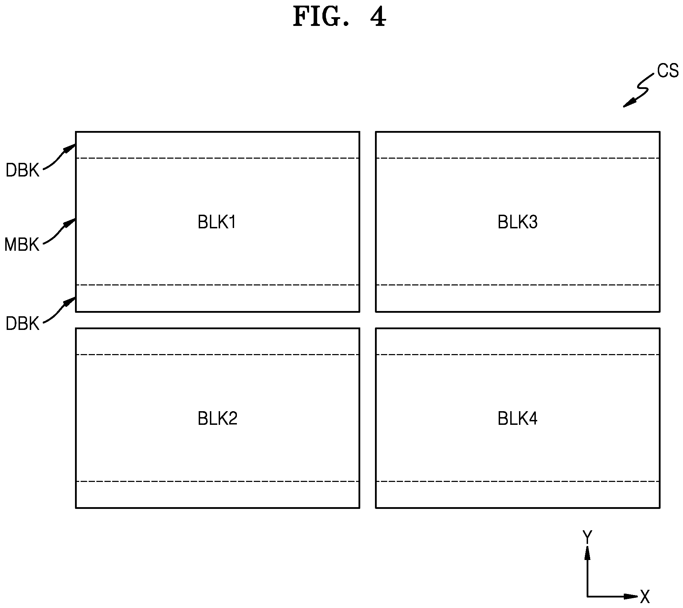

FIG. 4 is a schematic layout diagram of a nonvolatile memory device according to embodiments. Referring to FIG. 4, the cell array structure CS may include a plurality of memory cell blocks BLK1, BLK2, BLK3, and BLK4. The plurality of memory cell blocks BLK1, BLK2, BLK3, and BLK4 may be arranged to form rows and columns in the first horizontal direction (X-direction) and the second horizontal direction (Y-direction). The first horizontal direction (X-direction) may be an extension direction of each of the plurality of word lines WL (WL1, WL2, ..., WLn-1, and WLn) shown in FIG. 3, and the second horizontal direction (Y-direction) may be an extension direction of each of the plurality of bit lines BL (BL1, BL2, ..., and BLm) shown in FIG. 3. Each of the plurality of memory cell blocks BLK1, BLK2, BLK3, and BLK4 may include a plurality of memory cells.

As shown, each of the plurality of memory cell blocks BLK1, BLK2, BLK3, and BLK4 in a quad arrangement may include a main cell block MBK and a dummy cell block DBK. Advantageously, to improve device performance and yield, each of the plurality of memory cell blocks BLK1, BLK2, BLK3, and BLK4 may include one main cell block MBK, and a pair of dummy cell blocks DBK arranged at both sides of one main cell block MBK. The pair of dummy cell blocks DBK may extend in the first horizontal direction (X-direction) from both sides of one main cell block MBK in the second horizontal direction (Y-direction). For example, the dummy cell block DBK may extend in an extension direction of each of the plurality of word lines WL (WL1, WL2, ..., WLn-1, and WLn) shown in FIG. 3.

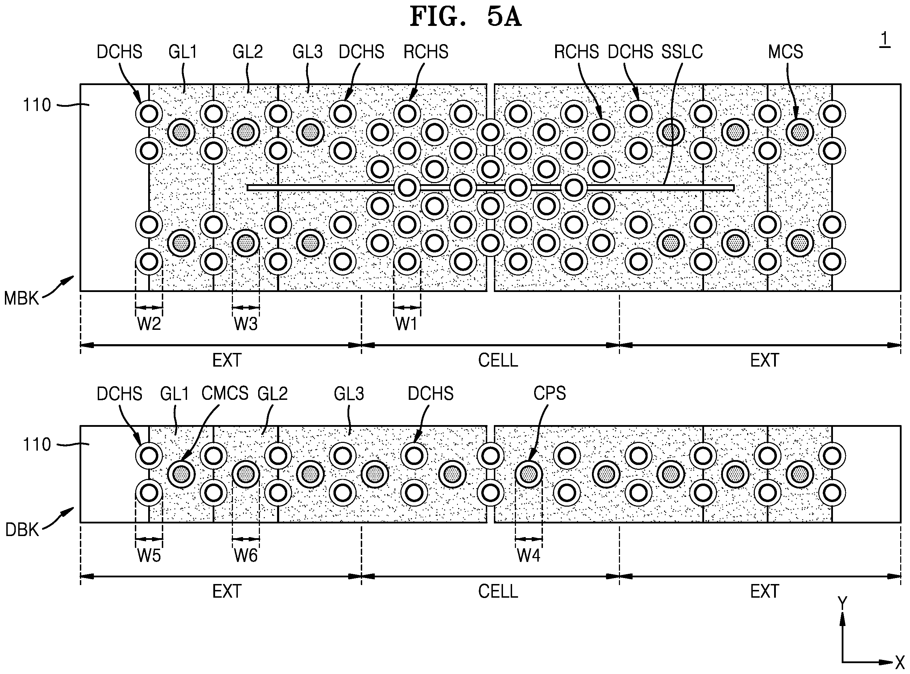

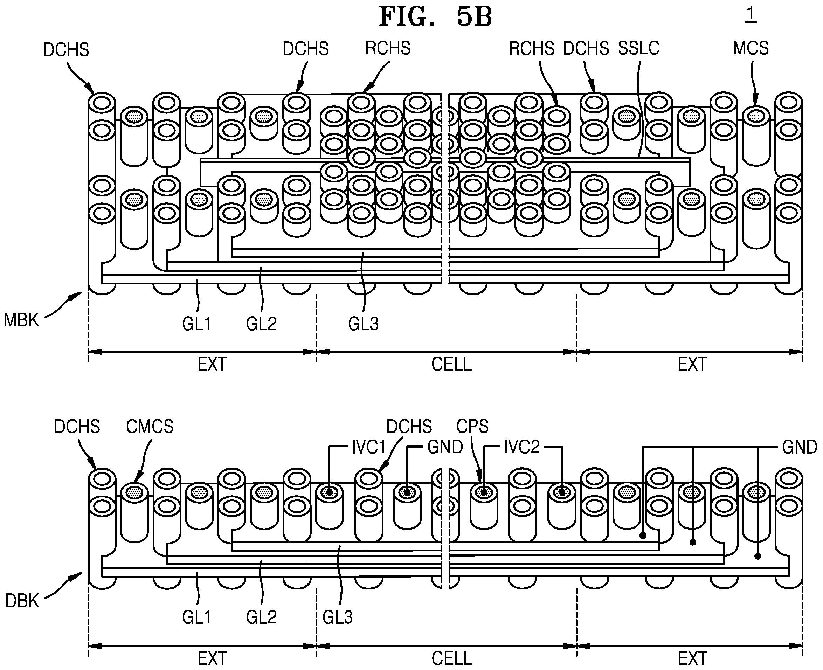

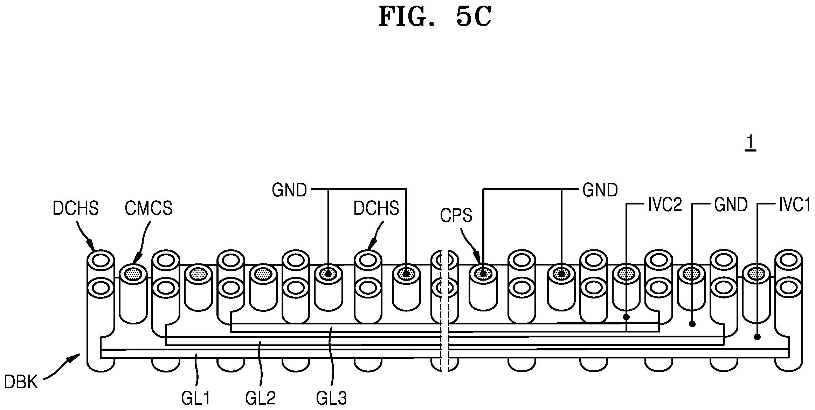

FIG. 5A is a plan view of a nonvolatile memory device according to embodiments, and FIGS. 5B and 5C are perspective views of a nonvolatile memory device according to embodiments. Referring to FIG. 5A, a nonvolatile memory device 1 may include a main cell block MBK and a dummy cell block DBK. The main cell block MBK and the dummy cell block DBK may be a main cell block MBK and a dummy cell block DBK of each of the plurality of memory cell blocks BLK1, BLK2, BLK3, and BLK4 shown in FIG. 4. Each of the main cell block MBK and the dummy cell block DBK may include a cell area CELL and a connection area EXT.

Each of the main cell block MBK and the dummy cell block DBK may include a plurality of gate electrodes GL1, GL2, and GL3 stacked on a substrate 110. FIGS. 5A and 5B illustrate that three gate electrodes, i.e., a first gate electrode GL1, a second gate electrode GL2, and a third gate electrode GL3, are stacked on the substrate 110. However, this is for convenience of illustration, and embodiments are not limited thereto. For example, each of the main cell block MBK and the dummy cell block DBK may include several tens or several hundreds of gate electrodes sequentially stacked on the substrate 110.

The plurality of gate electrodes GL1, GL2, and GL3 may be the plurality of word lines WL (WL1, WL2, ..., WLn-1, and WLn) shown in FIG. 3. The plurality of gate electrodes GL1, GL2, and GL3 may include the first gate electrode GL1, the second gate electrode GL2, and the third gate electrode GL3, which are sequentially stacked on the substrate 110. Each of the first gate electrode GL1, the second gate electrode GL2, and the third gate electrode GL3 may extend in the first horizontal direction (X-direction). An extension length of the gate electrode located on the lower side of the plurality of gate electrodes GL1, GL2, and GL3 may be greater in the first horizontal direction (X-direction) than that of the gate electrode located on the upper side of the plurality of gate electrodes GL1, GL2, and GL3. For example, the extension length of the first gate electrode GL1 may be greater than the extension length of the second gate electrode GL2, and the extension length of the second gate electrode GL2 may be greater than the extension length of the third gate electrode GL3.

The cell area CELL may be a portion in which a central portion of each of the plurality of gate electrodes GL1, GL2 and GL3, i.e., a portion excluding a portion of both ends of each of the plurality of gate electrodes GL1, GL2 and GL3, overlaps another in the first horizontal direction (X-direction). For example, the cell area CELL may include a portion excluding a portion of both ends of an uppermost gate electrode of the plurality of gate electrodes GL1, GL2 and GL3, for example, the third gate electrode GL3 and a portion of the other gate electrodes of the plurality of gate electrodes GL1, GL2 and GL3 that overlap the portion in the vertical direction, for example, a portion of each of the second gate electrode GL2 and the first gate electrode GL1.

The connection area EXT may include portions of the plurality of gate electrodes GL1, GL2 and GL3 that are placed at both sides or one side of the cell area CELL in the first horizontal direction (X-direction) and have a staircase shape. For example, the connection area EXT may have a staircase shape in which the connection area EXT is far away from the cell area CELL and descends.

At least one uppermost gate electrode of the plurality of gate electrodes GL1, GL2, and GL3 may be flatly separated into two portions by a string selection line cut area SSLC. For example, one or two uppermost gate electrodes of the plurality of gate electrodes GL1, GL2, and GL3 may be flatly separated into two portions by the string selection line cut area SSLC. The string selection line cut area SSLC may pass through at least one uppermost gate electrode of the plurality of gate electrodes GL1, GL2, and GL3, for example, a third gate electrode GL3, and may extend in the first horizontal direction (X-direction). In some embodiments, at least one uppermost gate electrode of the plurality of gate electrodes GL1, GL2, and GL3, for example, the third gate electrode GL3, may be flatly separated into two portions by the string selection line cut area SSLC, and the two portions may be spaced apart from each other in a second horizontal direction (Y-direction) with the string selection line cut area SSLC therebetween. An insulating material may be filled in the string selection line cut area SSLC. The two portions that are flatly separated by the string selection line cut area SSLC may constitute the string selection line SSL shown in FIG. 3.

A plurality of cell channel structures RCHS may be arranged in the cell area CELL of the main cell block MBK. A plurality of cell contact structures MCS may be arranged in the connection area EXT of the main cell block MBK. A plurality of capacitor core contact structures CPS may be arranged in the cell area CELL of the dummy cell block DBK. A plurality of capacitor gate contact structures CMCS may be arranged in the connection area EXT of the dummy cell block DBK. A plurality of dummy channel structures DCHS may be arranged in at least one area of the connection area EXT of the main cell block MBK, the cell area CELL of the dummy cell block DBK, and the connection area EXT of the dummy cell block DBK. In some embodiments, a plurality of dummy channel structures DCHS may be arranged in each of the connection area EXT of the main cell block MBK, the cell area CELL of the dummy cell block DBK, and the connection area EXT of the dummy cell block DBK.

Each of the plurality of cell channel structures RCHS, the plurality of cell contact structures MCS, the plurality of dummy channel structures DCHS, the plurality of capacitor core contact structures CPS, and the plurality of capacitor gate contact structures CMCS may be spaced from each other in the horizontal direction. Each of the plurality of cell contact structures MCS and the plurality of capacitor core contact structures CPS may be electrically insulated from the plurality of gate electrodes GL1, GL2, and GL3. Each of the plurality of capacitor gate contact structures CMCS may be electrically connected to one of the plurality of gate electrodes GL1, GL2, and GL3. For example, each of the plurality of gate electrodes GL1, GL2, and GL3 may be electrically connected to at least one of the plurality of capacitor gate contact structures CMCS.

In some embodiments, the plurality of cell channel structures RCHS may be arranged in a honeycomb shape to be arranged in a zigzag manner with respect to a plurality of first horizontal directions (X-direction) or a plurality of second horizontal directions (Y-direction). In some embodiments, the plurality of cell channel structures RCHS may be arranged in a matrix shape in which the plurality of cell channel structures RCHS are arranged in one line in each of the first horizontal directions (X-direction) and the second horizontal directions (Y-direction).

In some embodiments, dummy channel structures DCHS may be arranged along the periphery of each of the plurality of cell contact structures MCS arranged in the connection area EXT of the main cell block MBK. For example, four dummy channel structures DCHS may be arranged at the periphery of one cell contact structure MCS. The four dummy channel structures DCHS may surround one cell contact structure MCS. That is, one cell contact structure MCS may be arranged in a space between the four dummy channel structures DCHS.

In some embodiments, dummy channel structures DCHS may be arranged along the periphery of each of the plurality of capacitor core contact structures CPS arranged in the cell area CELL of the dummy cell block DBK. For example, four dummy channel structures DCHS may be arranged at the periphery of one capacitor core contact structure CPS. The four dummy channel structures DCHS may surround one capacitor core contact structure CPS. That is, one capacitor core contact structure CPS may be arranged in a space between the four dummy channel structures DCHS.

In some embodiments, dummy channel structures DCHS may be arranged along the periphery of each of the plurality of capacitor gate contact structures CMCS arranged in the connection area EXT of the dummy cell block DBK. For example, four dummy channel structures DCHS may be arranged at the periphery of one capacitor gate contact structure CMCS. The four dummy channel structures DCHS may surround one capacitor gate contact structure CMCS. That is, one capacitor gate contact structure CMCS may be arranged in a space between the four dummy channel structures DCHS.

In the main cell block MBK, each of the plurality of cell channel structures RCHS may have a first horizontal width W1, and each of the plurality of dummy channel structures DCHS may have a second horizontal width W2, and each of the plurality of cell contact structures MCS may have a third horizontal width W3. In addition, in the dummy cell block DBK, each of the plurality of capacitor core contact structures CPS may have a fourth horizontal width W4, and each of the plurality of dummy channel structures DCHS may have a fifth horizontal width W5, and each of the plurality of capacitor gate contact structures CMCS may have a sixth horizontal width W6.

In some embodiments, the first horizontal width W1 and the second horizontal width W2 may have the same value. In the main cell block MBK, the plurality of cell channel structures RCHS and the plurality of dummy channel structures DCHS may have the same horizontal width. In some embodiments, the cell channel structure RCHS and the dummy channel structure DCHS may have substantially the same or similar structure and shape. In some embodiments, the cell channel structure RCHS and the dummy channel structure DCHS may have different structures and shapes. In some embodiments, the second horizontal width W2 and the fifth horizontal width W5 may have the same value. The plurality of dummy channel structures DCHS may have the same horizontal width in the main cell block MBK and the dummy cell block DBK. In some embodiments, the third horizontal width W3 and the sixth horizontal width W6 may have the same value. The plurality of cell contact structures MCS and the plurality of capacitor gate contact structures CMCS may have the same horizontal width. In some embodiments, the cell contact structure MCS and the capacitor gate contact structure CMCS may have substantially the same or similar structure and shape.

In some embodiments, the fourth horizontal width W4 and the sixth horizontal width W6 may have the same value. The plurality of capacitor core contact structures CPS and the plurality of capacitor gate contact structures CMCS may have the same horizontal width. In some embodiments, the capacitor core contact structure CPS and the capacitor gate contact structure CMCS may have substantially the same or similar structure and shape. In some embodiments, the first horizontal width W1, the second horizontal width W2, the third horizontal width W3, the fourth horizontal width W4, the fifth horizontal width W5, and the sixth horizontal width W6 may have the same value.

Referring to FIGS. 5A and 5B together, each of the plurality of cell channel structures RCHS, the plurality of cell contact structures MCS, the plurality of dummy channel structures DCHS, the plurality of capacitor core contact structures CPS, and the plurality of capacitor gate contact structures CMCS may pass through at least some gate electrodes of the plurality of gate electrodes GL1, GL2, and GL3. For example, the plurality of cell channel structures RCHS arranged in the cell area CELL of the main cell block MBK, and the plurality of dummy channel structures DCHS and the plurality of capacitor core contact structures CPS arranged in the cell area CELL of the dummy cell block DBK may pass through all of the plurality of gate electrodes GL1, GL2, and GL3. For example, the plurality of cell contact structures MCS arranged in the connection area EXT of the main cell block MBK, the plurality of capacitor gate contact structures CMCS arranged in the connection area EXT of the dummy cell block DBK, and the plurality of dummy channel structures DCHS may pass through a gate electrode or gate electrodes located at a lower side from a staircase-shaped tread portion in which each of the plurality of gate electrodes GL1, GL2 and GL3 is arranged.

A power supply or ground may be connected to a plurality of capacitor core contact structures CPS. For example, a first power supply IVC1 may be connected to a portion of the plurality of capacitor core contact structures CPS, whereas a second power supply IVC2 may be connected to other portions of the plurality of capacitor core contact structures CPS. In some embodiments, a ground GND may be connected to another portion of the plurality of capacitor core contact structures CPS. A ground GND may be connected to each of the plurality of gate electrodes GL1, GL2, and GL3.

For example, a first capacitor may be configured between the capacitor core contact structure CPS to which the first power supply IVC1 is connected, and the plurality of gate electrodes GL1, GL2, and GL3 connected to the ground GND, and a second capacitor may be configured between the capacitor core contact structure CPS to which the second power supply IVC2 is connected, and the plurality of gate electrodes GL1, GL2, and GL3 connected to the ground GND.

In some embodiments, the second power supply IVC2 may provide greater power than in the first power supply IVC1. For example, the second power supply IVC2 may provide a greater current and voltage than in the first power supply IVC1. Alternatively, for example, the same voltage as a voltage of the first power supply IVC1 may be provided to the second power supply IVC2 but a greater current than in the first power supply IVC1 may be provided to the second power supply IVC2. Alternatively, for example, the same current as a current of the first power supply IVC1 may be provided to the second power supply IVC2 but a greater voltage than in the first power supply IVC1 may be provided to the second power supply IVC2.

In some embodiments, the number of capacitor core contact structures CPS connected to the second power supply IVC2 of the plurality of capacitor core contact structures CPS may be greater than the number of capacitor core contact structures CPS connected to the first power supply IVC1. The capacitance of a capacitor of one capacitor core contact structure CPS may be substantially the same. Capacitor core contact structures CPS connected to one power supply may be connected in parallel. Thus, when a relatively large number of capacitor core contact structures CPS are connected to one power supply, a capacitor having a relatively large capacitance may be connected to one power supply. For example, a capacitance of the second capacitor may be greater than a capacitance of the first capacitor.

In some embodiments, a ground GND may be connected to the capacitor core contact structure CPS arranged between the capacitor core contact structure CPS to which the first power supply IVC1 is connected, and the capacitor core contact structure CPS to which the second power supply IVC2 is connected, so that electrical interference between the first capacitor and the second capacitor may be prevented.

Referring to FIGS. 5A and 5C together, the ground GND may be connected to the plurality of capacitor core contact structures CPS. A power or ground may be connected to each of the plurality of gate electrodes GL1, GL2, and GL3. For example, the first power supply IVC1 may be connected to a portion of the plurality of gate electrodes GL1, GL2, and GL3, and the second power supply IVC2 may be connected to other portions of the plurality of gate electrodes GL1, GL2, and GL3. In some embodiments, the ground GND may be connected to another portion of the plurality of gate electrodes GL1, GL2, and GL3. For example, the first power supply IVC1 may be connected to the first gate electrode GL1, the second power supply IVC2 may be connected to the third gate electrode GL3, and the ground GND may be connected to the second gate electrode GL2 located between the first gate electrode GL1 and the third gate electrode GL3.

For example, the first capacitor may be configured between the first gate electrode GL1 to which the first power supply IVC1 is connected, and the plurality of capacitor core contact structures CPS connected to the ground GND, and the second capacitor may be configured between the third gate electrode GL3 to which the second power supply IVC2 is connected, and the plurality of capacitor core contact structures CPS connected to the ground GND.

In some embodiments, the second power supply IVC2 may provide greater power than in the first power supply IVC1. For example, the second power supply IVC2 may provide a greater current and voltage than in the first power supply IVC1. Alternatively, for example, the same voltage as the voltage of the first power supply IVC1 may be provided to the second power supply IVC2 but a greater current than in the first power supply IVC1 may be provided to the second power supply IVC2. Alternatively, for example, the same current as the current of the first power supply IVC1 may be provided to the second power supply IVC2 but a greater voltage than in the first power supply IVC1 may be provided to the second power supply IVC2.

FIG. 5C illustrates that the first power supply IVC1 and the second power supply IVC2 are connected to one gate electrode, i.e., the first gate electrode GL1 and the third gate electrode GL3, respectively. However, this is for convenience of illustration, and embodiments are not limited thereto. For example, the number of gate electrodes connected to the second power supply IVC2 for providing relatively large power may be greater than the number of gate electrodes connected to the first power supply IVC1 for providing relatively small power. In some embodiments, a ground GND may be connected to the second gate electrode GL2 arranged between the first gate electrode GL1 to which the first power supply IVC1 is connected and the third gate electrode GL3 to which the second power supply IVC2 is connected, so that electrical interference between the first capacitor and the second capacitor may be prevented.

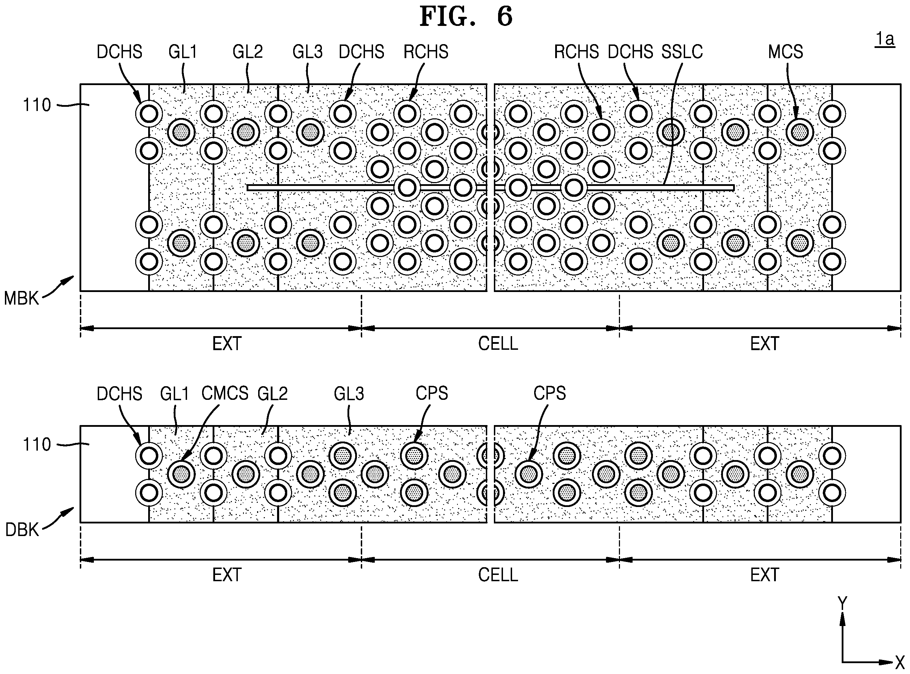

FIG. 6 is a plan view of a nonvolatile memory device according to embodiments. Referring to FIG. 6, a nonvolatile memory device 1a may include a main cell block MBK and a dummy cell block DBK. Each of the main cell block MBK and the dummy cell block DBK may include a cell area CELL and a connection area EXT. Each of the main cell block MBK and the dummy cell block DBK may include a plurality of gate electrodes GL1, GL2, and GL3 stacked on the substrate 110.

A plurality of cell channel structures RCHS may be arranged in the cell area CELL of the main cell block MBK. A plurality of cell contact structures MCS may be arranged in the connection area EXT of the main cell block MBK. A plurality of capacitor core contact structures CPS may be arranged in the cell area CELL of the dummy cell block DBK. A plurality of capacitor gate contact structures CMCS may be arranged in the connection area EXT of the dummy cell block DBK. A plurality of dummy channel structures DCHS may be arranged in at least one area of the connection area EXT of the main cell block MBK and the connection area EXT of the dummy cell block DBK. In some embodiments, a plurality of dummy channel structures DCHS may be arranged in each of the connection area EXT of the main cell block MBK and the connection area EXT of the dummy cell block DBK, and the dummy channel structure DCHS may not be arranged in the cell area CELL of the dummy cell block DBK.

In some embodiments, the plurality of capacitor core contact structures CPS may be arranged in a honeycomb shape, which may include being arranged in a zigzag manner with respect to the first horizontal direction (X-direction) or the second horizontal direction (Y-direction). In some embodiments, the plurality of capacitor core contact structures CPS may be arranged in a matrix shape in which the plurality of capacitor core contact structures CPS are arranged in one line in each of the first horizontal direction (X-direction) and the second horizontal direction (Y-direction).

In some embodiments, dummy channel structures DCHS may be arranged along the periphery of each of the plurality of cell contact structures MCS arranged in the connection area EXT of the main cell block MBK. In some embodiments, other capacitor core contact structures CPS may be arranged at the periphery of each of a plurality of capacitor core contact structures CPS arranged in the cell area CELL of the dummy cell block DBK. For example, other four capacitor core contact structures CPS may be arranged at the periphery of one capacitor core contact structure CPS.

In the nonvolatile memory device 1a, a relatively large number of capacitor core contact structures CPS may be arranged in the cell area CELL of the dummy cell block DBK. Thus, the plurality of capacitor core contact structures CPS arranged in the cell area CELL of the dummy cell block DBK may constitute a relatively large number of capacitors, or a capacitor having a relatively high capacitance.

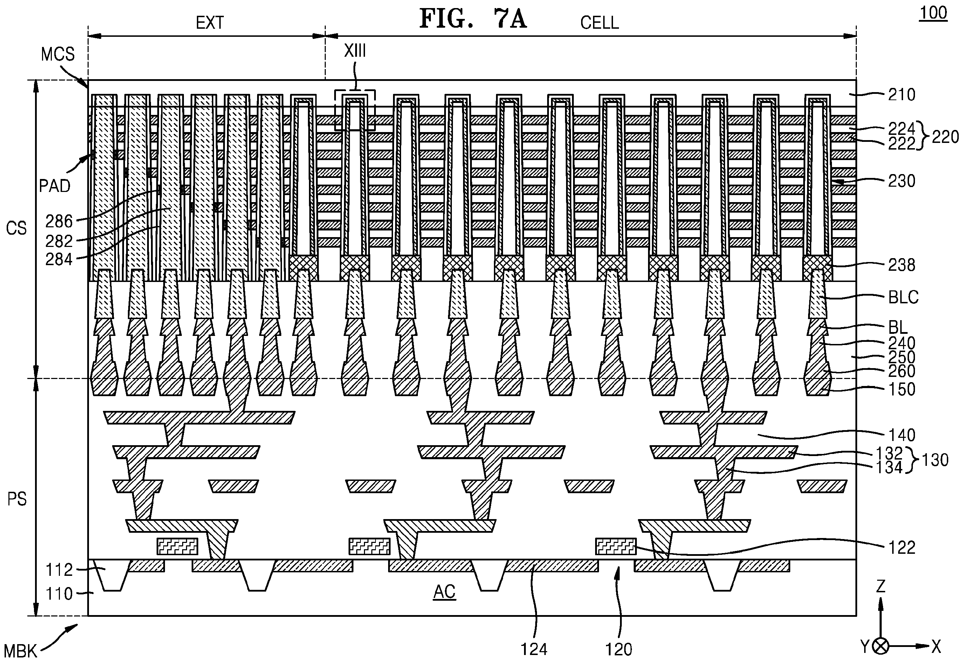

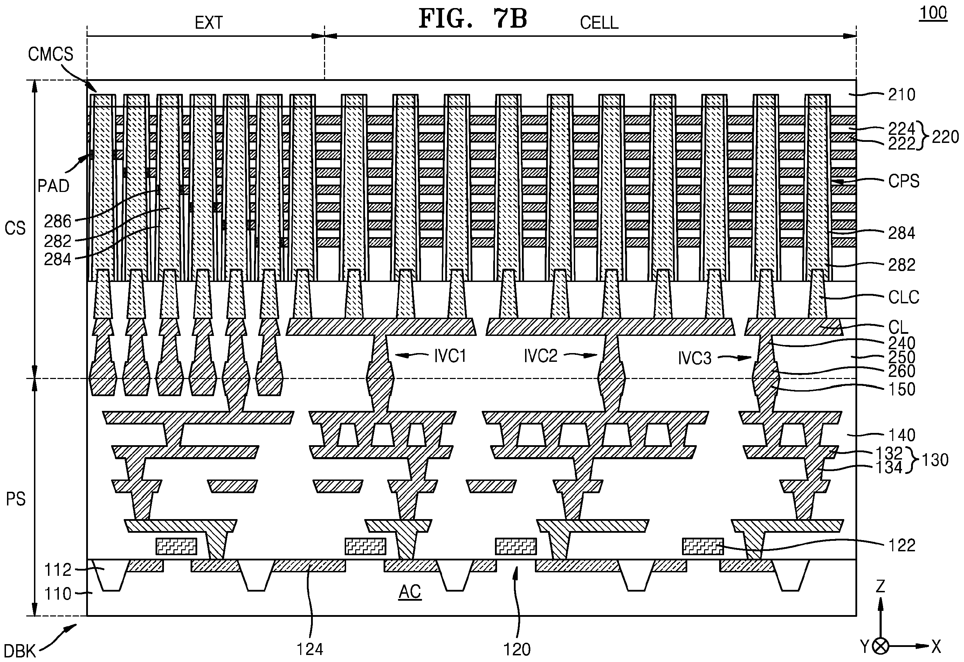

FIGS. 7A and 7B are cross-sectional views of a nonvolatile memory device according to embodiments. Referring to FIGS. 7A and 7B together, a nonvolatile memory device 100 may include a peripheral circuit structure PS and a cell array structure CS, which are bonded to each other in the vertical direction (Z-direction). The peripheral circuit structure PS and the cell array structure CS may be referred to as a first structure and a second structure, respectively. The peripheral circuit structure PS may include the peripheral circuit 30 described with reference to FIG. 1, and the cell array structure CS may include the memory cell array 20 described with reference to FIG. 1. In a planar viewpoint, the nonvolatile memory device 100 may include a main cell block MBK and a dummy cell block DBK arranged at least one side of the main cell block MBK. In some embodiments, the dummy cell block DBK may be arranged at both sides of the main cell block MBK. For example, the pair of dummy cell blocks DBK may extend in the first horizontal direction (X-direction) from both sides of one main cell block MBK in the second horizontal direction (Y-direction).

The cell array structure CS of each of the main cell block MBK and the dummy cell block DBK may include a cell area CELL and a connection area EXT. The main cell block MBK may be one of the plurality of memory cell blocks BLK1, BLK2, ..., and BLKn described with reference to FIG. 1. Each of the plurality of memory cell blocks BLK1, BLK2, ..., and BLKn may include a plurality of memory cells, which are arranged in a 3D manner. The peripheral circuit structure PS may include a substrate 110, a peripheral circuit 120 on the substrate 110, a first interconnect structure 130 electrically connected to the peripheral circuit 120, a first insulating structure 140 on the substrate 110 and the peripheral circuit 120, and a first bonding pad 150 on the first insulating structure 140.

The substrate 110 may include a semiconductor material, such as a IV-group semiconductor material, a III-V-group semiconductor material or a II-VI-group semiconductor material, or a II-VI-group oxide semiconductor material. The IV-group semiconductor material may include, for example, silicon (Si), germanium (Ge), or Si-Ge. The I II-V-group semiconductor material may include gallium arsenic (GaAS), indium phosphorus (InP), gallium phosphorus (GaP), indium arsenic (InAs), indium antimon (InSb), or indium gallium arsenic (InGaAs). The II-VI-group semiconductor material may include, for example, telerurization zinc (ZnTe) or sulfide cadmium (CdS). The substrate 110 may be a bulk wafer or an epitaxial layer. In another embodiment, the substrate 110 may include a silicon-on-insulator (SOI) substrate or a germanium-on-insulator (GeOI) substrate. An active area AC may be defined by an isolation layer 112 in the substrate 110, and a plurality of peripheral circuits 120 may be formed on the active area AC. The plurality of peripheral circuits 120 may include a peripheral circuit gate 122, and a source/drain area 124 arranged in a portion of the substrate 110 at both sides of the peripheral circuit gate 122.

The first interconnect structure 130 may include a plurality of peripheral circuit wiring layers 132 and a plurality of peripheral circuit contacts 134. The first interconnect structure 130 may include a conductive material, such as copper (Cu), aluminum (Al), tungsten (W), silver (Ag), gold (Au), or a combination thereof. The first insulating structure 140 may cover the peripheral circuit 120 and the first interconnect structure 130 on the substrate 110. The first bonding pad 150 may be arranged on the first insulating structure 140 and may be electrically connected to the peripheral circuit 120 and/or the substrate 110 through the first interconnect structure 130. The first bonding pad 150 may have a top surface arranged on the same plane as the top surface of the first insulating structure 140.

In example embodiments, the first insulating structure 140 may include an insulating material, such as silicon oxide, silicon nitride, a low dielectric constant (low-k) material, or a combination thereof. The low dielectric constant (low-k) material that is a material having a lower dielectric constant than that of silicon oxide may include, for example, phosphosilicate glass (PSG), borophosphosilicate glass (BPSG), fluorosilicate glass (FSG), organosilice glass (OSG), spin-on glass (SOG), spin-on-polymer, or a combination thereof. In some embodiments, the first insulating structure 140 may include an ultra low k (ULK) layer having an ultra low dielectric constant K of about 2.2 to 2.4. The ULK layer may include SiOC or SiCOH. The first bonding pad 150 may include a conductive material, such as copper (Cu), gold (Au), silver (Ag), aluminum (Al), tungsten (W), titanium (Ti), tantalum (Ta), or a combination thereof.

The cell array structure CS may include a common source line layer 210, a cell stack 220 arranged on the common source line layer 210, a second interconnect structure 240 electrically connected to the cell stack 220, a second insulating structure 250 for covering the second interconnect structure 240, and a second bonding pad 260 on the second insulating structure 250. The second bonding pad 260 may have a bottom surface arranged on the same plane as the bottom surface of the second insulating structure 250. FIGS. 7A and 7B illustrate that the second interconnect structure 240 includes a plurality of contacts. However, this is just an example, and embodiments are not limited thereto. For example, the second interconnect structure 240 may include a plurality of contacts and a plurality of wiring layers. Each of the second interconnect structure 240 and the second insulating structure 250 may include a material that is the same as or similar to a material for forming each of the first interconnect structure 130 and the first insulating structure 140.

The second insulating structure 250 may be in contact with the first insulating structure 140 and the first bonding pad 150 to which the second bonding pad 260 corresponds, so that the cell array structure CS may be bonded to the peripheral circuit structure PS. For example, the peripheral circuit structure PS and the cell array structure CS may be bonded to each other in a metal-oxide hybrid bonding manner. Thus, the second interconnect structure 240 included in the cell array structure CS may be electrically connected to the peripheral circuit 120 included in the peripheral circuit structure PS.

The cell stack 220 may include a plurality of gate electrodes 222 and a plurality of insulating layers 224, which are alternately arranged on the common source line layer 210. The plurality of gate electrodes 222 may be the plurality of gate electrodes GL1, GL2, and GL3 shown in FIGS. 5A through 6. The plurality of gate electrodes 222 may include W, Cu, Ag, Au, Al, or a combination thereof but may include a conductive material that is not limited thereto. The plurality of insulating layers 224 may include an insulating material, such as silicon oxide, silicon nitride, a low dielectric constant material, or a combination thereof.

A plurality of cell channel structures 230 that pass through the cell stack 220 including the plurality of gate electrodes 222 and the plurality of insulating layers 224 and extend in the vertical direction may be arranged in the cell area CELL. The plurality of cell channel structures 230 may be the plurality of cell channel structures RCHS shown in FIGS. 5A through 6. The memory cell string (MS of FIG. 3) including a plurality of memory cells may be formed along each of the plurality of cell channel structures 230.

The common source line layer 210 may function as a source area for supplying a current to memory cells formed in the cell array structure CS. The common source line layer 210 may include a semiconductor material, such as a IV-group semiconductor material, a III-V-group semiconductor material, or a II-VI-group semiconductor material. For example, the common source line layer 210 may include at least one of Si, germanium (Ge), silicon germanium (SiGe), gallium arsenic (GaAs), indicum gallium arsenic (InGaAs), aluminum gallium arsenic (AlGaAs), and a mixture thereof. Also, the common source line layer 210 may include a semiconductor doped with n-type impurities. Also, the common source line layer 210 may have a crystalline structure including at least one selected from the group consisting of monocrystalline, amorphous, and polycrystalline. In some embodiments, the common source line layer 210 may include a semiconductor material that does not include carbon. For example, the common source line layer 210 may include polysilicon. In some embodiments, the common source line layer 210 may include polysilicon that does not include carbon. In some embodiments, the common source line layer 210 may include polysilicon doped with n-type impurities. The common source line layer 210 may be arranged in such a way that the cell channel structure 230 passes through the plurality of gate electrodes 222 and the plurality of insulating layers 224 and is in contact with the common source line layer 210. FIG. 7A illustrates that the common source line layer 210 is formed integrally in the cell area CELL and the connection area EXT, but this is an example for convenience of illustration, and embodiments are not limited thereto. For example, portions of the common source line layer 210 arranged in each of the cell area CELL and the connection area EXT may be separated from each other. Alternatively, for example, there may be a plurality of common source line layers 210, which are arranged in the cell area CELL and spaced apart from each other.

In some embodiments, the plurality of gate electrodes 222 may correspond to at least one ground selection line GSL, word lines WL (WL1, WL2, ..., WLn-1, and WLn), and at least one string selection line SSL, which constitute the memory cell string MS shown in FIG. 3. For example, the gate electrode 222, which is the closest to the common source line layer 210, may function as a ground selection line GSL, and two gate electrodes 222, which are the farthest from the common source line layer 210, may function as a string selection line SSL, and the other gate electrode 222 may function as a word line WL. Thus, a memory cell string MS, in which a ground selection transistor GST, a string selection transistor SST and memory cell transistors MC1, MC2, ...., MCn-1 and MCn therebetween are connected in series, may be provided.

In some embodiments, at least one of the gate electrodes 222 may function as a dummy word line. For example, at least one gate electrode 222 functioning as an additional dummy word line may be arranged between the gate electrode 222 functioning as the ground selection line GSL and the common source line layer 210, or at least one gate electrode 222 functioning as an additional dummy word line may be arranged between the gate electrode 222 functioning as the ground selection line GSL and the gate electrode 222 functioning as the word line WL, or at least one gate electrode 222 functioning as an additional dummy word line may be arranged between the gate electrode 222 functioning as the word line WL and the gate electrode 222 functioning as the string selection line SSL.

In the cell area CELL of the main cell block MBK, the plurality of cell channel structures 230 may pass through the plurality of gate electrodes 222 and the plurality of insulating layers 224 and may extend from the top surface of the common source line layer 210 in the vertical direction (Z-direction). The plurality of cell channel structures 230 may be spaced apart from each other in a first horizontal direction (X-direction), a second horizontal direction (Y-direction), and a third direction (e.g., an oblique direction with respect to the first horizontal direction (X-direction) and the second horizontal direction (Y-direction)) at certain intervals and arranged. The plurality of cell channel structures 230 may be arranged in a zigzag form or a staggered form. Each of the plurality of cell channel structures 230 may include a conductive plug 238. The conductive plug 238 may be arranged on one end of each of the plurality of cell channel structures 230 opposite to the common source line layer 210.

The bit line BL may be spaced apart from each other in the second horizontal direction (Y-direction) and may extend and may be electrically connected to the cell channel structure 230 by a bit line contact BLC. The bit line contact BLC may be connected to the conductive plug 238.

In the connection area EXT, the plurality of gate electrodes 222 may constitute a pad portion PAD. In some embodiments, in the connection area EXT, the plurality of gate electrodes 222 may extend to have a smaller length in the first horizontal direction (X-direction) as being distant from the top surface of the common source line layer 210. In some embodiments, in the connection area EXT, the plurality of gate electrodes 222 may extend to have a smaller length in the first horizontal direction (X-direction) and the second horizontal direction (Y-direction) as being distant from the top surface of the common source line layer 210. The pad portion PAD may refer to portions of the gate electrode 222 arranged in a staircase shape. In some embodiments, the pad portion PAD may have a staircase shape in the first horizontal direction (X-direction). In other embodiments, the pad portion PAD may have a staircase shape in each of the first horizontal direction (X-direction) and the second horizontal direction (Y-direction). FIGS. 7A and 7B illustrate that the plurality of gate electrodes 222 constituting the pad portion PAD and the plurality of gate electrodes 222 arranged in the cell area CELL have the same thickness. However, in other embodiments, the plurality of gate electrodes 222 constituting the pad portion PAD may have a greater thickness than those of the plurality of gate electrodes 222 arranged in the cell area CELL.

In the cell area CELL and/or the connection area EXT, a plurality of dummy channel structures (DCHS of FIGS. 5A through 6) that pass through the plurality of gate electrodes 222 and the plurality of insulating layers 224 and extend from the top surface of the common source line layer 210 in the vertical direction (Z-direction) may be further formed. The plurality of dummy channel structures DCHS may be formed to prevent lining or bending of the gate electrodes 222 in a process of fabricating the nonvolatile memory device 100 and to secure structural stability. In some embodiments, the dummy channel structure DCHS may have a structure and shape substantially the same as or similar to that of the cell channel structure 230. In some embodiments, the cell channel structure RCHS and the dummy channel structure DCHS may have different structures and shapes.

A second insulating structure 250 may be arranged on the plurality of gate electrodes 222 that constitute the pad portion PAD. The second insulating structure 250 may include a plurality of insulating layers, and each of the plurality of insulating layers may be arranged to cover the pad portion PAD, the cell stack 220, the bit line contact BLC, and the second interconnect structure 240.

A plurality of cell contact structures MCS may be arranged in the connection area EXT of the main cell block MBK, may pass through the second insulating structure 250 and may be connected to the gate electrodes 222. A bit line contact BLC, and a bit line BL connected to the bit line contact BLC may be arranged on each of the plurality of cell contact structures MCS, and the bit line BL may be connected to the second interconnect structure 240. In some embodiments, in the connection area EXT of the main cell block MBK, the plurality of cell contact structures MCS may pass through the plurality of gate electrodes 222 and the plurality of insulating layers 224 and may extend from the top surface of the common source line layer 210 in the vertical direction (Z-direction).

In the cell area CELL of the dummy cell block DBK, the plurality of capacitor core contact structures CPS may pass through the plurality of gate electrodes 222 and the plurality of insulating layers 224 and may extend from the top surface of the common source line layer 210 in the vertical direction (Z-direction). In the connection area EXT of the dummy cell block DBK, the plurality of capacitor gate contact structures CMCS may pass through the plurality of gate electrodes 222 and the plurality of insulating layers 224 and may extend from the top surface of the common source line layer 210 in the vertical direction (Z-direction).

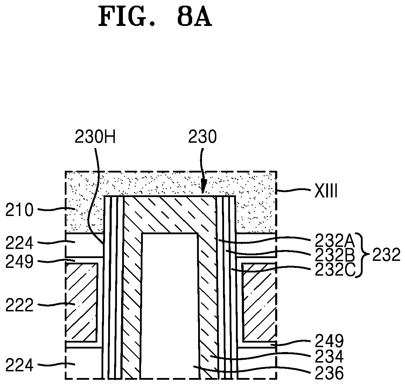

In some embodiments, the plurality of cell contact structures MCS, the plurality of capacitor core contact structures CPS, and the plurality of capacitor gate contact structures CMCS may have substantially the same or similar structures and shapes. For example, each of the plurality of cell contact structures MCS, the plurality of capacitor core contact structures CPS, and the plurality of capacitor gate contact structures CMCS may include a core conductor 282 (which in one example may be referred to as a first core conductor), and a cover insulating layer 284 (which in one example may be referred to as a first cover insulating layer) that surrounds the periphery of the core conductor 282. For example, the cover insulating layer 284 may cover the side surface of the core conductor 282. The cover insulating layer 284 may be located between the core conductor 282 and the plurality of gate electrodes 222. The core conductor 282 may include a material that is the same as or similar to a material for forming the second interconnect structure 240. The cover insulating layer 284 may include a material that is the same as or similar to a material for forming at least a portion of the gate insulating layer 232 shown in FIGS. 8A through 10.

In some embodiments, each of the plurality of cell contact structures MCS and the plurality of capacitor gate contact structures CMCS may further include a connection conductor 286 that passes through the cover insulating layer 284 and electrically connects the core conductor 282 to the gate electrodes 222. The connection conductor 286 may include a material that is the same as or similar to a material for forming the gate electrodes 222.

FIGS. 7A and 7B illustrate that the connection conductor 286 is located at the same vertical level as the gate electrodes 222 electrically connected to the connection conductor 286. However, this is an example, and embodiments are not limited thereto. In some embodiments, the connection conductor 286 may be arranged on the bottom surface of the gate electrodes 222 electrically connected to the connection conductor 286, thereby electrically connecting the core conductor 282 to the gate electrodes 222.

The plurality of cell contact structures MCS arranged in the connection area EXT of the main cell block MBK may be electrically connected to the plurality of gate electrodes 222 arranged in the cell area CELL of the main cell block MBK.

The plurality of capacitor gate contact structures CMCS arranged in the connection area EXT of the dummy cell block DBK may be electrically connected to the plurality of gate electrodes 222 arranged in the cell area CELL of the dummy cell block DBK. The plurality of gate electrodes 222 arranged in the cell area CELL of the dummy cell block DBK, the core conductor 282 of each of the plurality of capacitor core contact structures CPS, and the cover insulating layer 284 that surrounds the core conductor 282 of each of the plurality of capacitor core contact structures CPS may constitute a capacitor.

Power or ground may be connected to the core conductors 282 of the plurality of capacitor core contact structures CPS. For example, a first power IVC1 may be connected to portions of the core conductors 282 of the plurality of capacitor core contact structures CPS, and a second power IVC2 may be connected to other portions of the core conductors 282 of the plurality of capacitor core contact structures CPS, and a third power IVC3 may be connected to another portions of the core conductors 282 of the plurality of capacitor core contact structures CPS. In some embodiments, a ground GND may be connected to another portion of the plurality of capacitor core contact structures CPS, as shown in FIG. 5B. The ground GND may be connected to each of the plurality of gate electrodes 222.

For example, the core conductors 282 of the capacitor core contact structures CPS to which the first power IVC1 is connected, the plurality of gate electrodes 222 connected to the ground GND, and the cover insulating layer 284 located therebetween may constitute a first capacitor, and the core conductors 282 of the capacitor core contact structures CPS to which the second power IVC2 is connected, the plurality of gate electrodes 222 connected to the ground GND, and the cover insulating layer 284 located therebetween may constitute a second capacitor, and the core conductors 282 of the capacitor core contact structures CPS to which the third power IVC3 is connected, the plurality of gate electrodes 222 connected to the ground GND, and the cover insulating layer 284 located therebetween may constitute a third capacitor.

The capacitor core contact structures CPS that constitute the first capacitor, the second capacitor, and the third capacitor among the plurality of capacitor core contact structures CPS may be referred to as a first capacitor core contact structure group, a second capacitor core contact structure group, and a third capacitor core contact structure group.

In some embodiments, the second power supply IVC2 may provide a greater power than in the first power supply IVC1, and the first power supply IVC1 may provide a greater power than in the third power supply IVC3. For example, the second power supply IVC2 may provide a greater current and a greater voltage than in the first power supply IVC1, and the first power supply IVC1 may provide a greater current and a greater voltage than in the third power supply IVC3. Alternatively, for example, the second power supply IVC2 may provide the same voltage as a voltage of the first power supply IVC1 but may provide a greater current than in the first power supply IVC1, and the first power supply IVC1 may provide the same voltage as in the third power supply IVC3 but may provide a greater current than in the third power supply IVC3. Alternatively, for example, the second power supply IVC2 may provide the same current as in the first power supply IVC1 but may provide a greater voltage than in the first power supply IVC1, and the first power supply IVC1 may provide the same current as in the third power supply IVC3 but may provide a greater voltage than in the third power supply IVC3.

The core conductors 282 may be electrically connected to the first interconnect structure 130 through the capacitor contact CLC, the capacitor line pattern CL, and the second interconnect structure 240. Each of the capacitor contact CLC and the capacitor line pattern CL may be located at the same vertical level as that of the bit line contact BLC and the bit line BL. In some embodiments, the capacitor contact CLC may be formed together with the bit line contact BLC and may include the same material as a material for forming the bit line contact BLC, and the capacitor line pattern CL may be formed together with the bit line BL and may include the same material as a material for forming the bit line BL.

In some embodiments, portions of the core conductors 282 of the plurality of capacitor core contact structures CPS may be electrically connected to each other through the capacitor line pattern CL. The core conductors 282 of the capacitor core contact structures CPS of the first capacitor core contact structure group may be electrically connected to each other through the capacitor line pattern CL. The core conductors 282 of the capacitor core contact structures CPS of the second capacitor core contact structure group may be electrically connected to each other through the capacitor line pattern CL. The core conductors 282 of the capacitor core contact structures CPS of the third capacitor core contact structure group may be electrically connected to each other through the capacitor line pattern CL.

Each of the capacitor line patterns CL electrically connected to the core conductors 282 of the capacitor core contact structures CPS of the first capacitor core contact structure group, the second capacitor core contact structure group, and the third capacitor core contact structure group may be referred to as a first capacitor line pattern, a second capacitor line pattern, and a third capacitor line pattern, respectively.

The first capacitor line pattern, the second capacitor line pattern, and the third capacitor line pattern may be spaced apart from each other. For example, the first capacitor line pattern, the second capacitor line pattern, and the third capacitor line pattern may be insulated from each other by the second insulating structure 250.

The second interconnect structure 240 and the first interconnect structure 130 may be electrically connected to each other through the second bonding pad 260 and the first bonding pad 150 that come into contact with each other and are bonded to each other.

The number of capacitor core contact structures CPS of the second capacitor core contact structure group may be greater than the number of capacitor core contact structures CPS of the first capacitor core contact structure group. For example, the number of the core conductors 282 of the capacitor core contact structures CPS electrically connected to the second power supply IVC2 among the core conductors 282 of the plurality of capacitor core contact structures CPS may be greater than the number of the core conductors 282 of the capacitor core contact structures CPS electrically connected to the first power supply IVC1.

The number of capacitor core contact structures CPS of the first capacitor core contact structure group may be greater than the number of capacitor core contact structures CPS of the third capacitor core contact structure group. For example, the number of the core conductors 282 of the capacitor core contact structures CPS electrically connected to the first power supply IVC1 among the core conductors 282 of the plurality of capacitor core contact structures CPS may be greater than the number of the core conductors 282 of the capacitor core contact structures CPS electrically connected to the third power supply IVC3.

Capacitances of capacitors formed by the core conductors 282, the plurality of gate electrodes 222, and the cover insulating layer 284 located therebetween of one capacitor core contact structure CPS may be substantially the same. The core conductors 282 of the capacitor core contact structure CPS connected to one power supply may be connected in parallel. Thus, when core conductors 282 of a relatively large number of capacitor core contact structures CPS are connected to one power supply, a capacitor having a relatively large capacitance may be connected to one power supply. For example, the capacitance of the second capacitor may be greater than the capacitance of the first capacitor, and the capacitance of the first capacitor may be greater than the capacitance of the third capacitor.

In some embodiments, the capacitor line pattern CL for electrically connecting portions of the core conductors 282 of the plurality of capacitor core contact structures CPS may extend in a different direction from a direction of the bit line BL. For example, the capacitor line pattern CL may extend in a first horizontal direction (X-direction), and the bit line BL may extend in a second horizontal direction (Y-direction).

Capacitor core contact structures CPS that constitutes a capacitor to which one power supply is connected together, may be electrically connected to the peripheral circuit 120 to which a corresponding power supply is connected. In some embodiments, the core conductors 282 of the capacitor core contact structures CPS that constitute a capacitor to which one power supply is together connected, may be electrically connected to the peripheral circuit 120 to which the corresponding power supply is connected, through the capacitor contact CLC, the capacitor line pattern CL, the second interconnect structure 240, the second bonding pad 260, the first bonding pad 150, and the first interconnect structure 130. For example, the capacitor core contact structure CPS may be electrically connected to the source/drain area 124 of the peripheral circuit 120.

In some embodiments, at least a portion of the capacitor core contact structures CPS that constitutes a capacitor to which one power supply is together connected, may overlap the peripheral circuit 120 to which the corresponding power supply is connected, in the vertical direction (Z-direction).

In the nonvolatile memory device 100 according to the inventive concept, at least a portion of the capacitor core contact structures CPS that constitute a capacitor connected to the peripheral circuit 120 overlaps the peripheral circuit 120 in the vertical direction (Z-direction) so that an electrical connection path between the peripheral circuit 120 and the capacitor connected to the peripheral circuit 120 may be minimized and a connection degree of freedom may increase. Thus, the efficiency of the capacitor connected to the peripheral circuit 120 may increase so that noise may be prevented from occurring in the power supply supplied to the peripheral circuit 120. Thus, the nonvolatile memory device 100 according to the inventive concept may have an operation reliability.

FIGS. 8A through 8C are enlarged cross-sectional views illustrating a cell channel structure of a nonvolatile memory device according to embodiments. In detail, FIGS. 8A through 8C are enlarged cross-sectional views illustrating an XIII portion of FIG. 7A. Referring to FIG. 8A, each of the plurality of cell channel structures 230 may be arranged in a channel hole 230H in the cell area CELL of the main cell block MBK. Each of the plurality of cell channel structures 230 may include a gate insulating layer 232, a channel layer 234, a buried insulating layer 236, and a conductive plug 238 (not shown here). The gate insulating layer 232 and the channel layer 234 may be sequentially arranged on a sidewall of the channel hole 230H. For example, the gate insulating layer 232 may be arranged conformally on the sidewall of the channel hole 230H, and the channel layer 234 may be arranged conformally on the sidewall and the bottom of the channel hole 230H. The channel layer 234 may be arranged to come into contact with the top surface of the common source line layer 210 at the bottom of the channel hole 230H. The buried insulating layer 236 for filling the residual space of the channel hole 230H may be arranged on the channel layer 234. A conductive plug (238 of FIG. 7A) may be arranged at the upper side of the channel hole 230H, may come into contact with the channel layer 234 and close the inlet of the channel hole 230H. In other embodiments, the buried insulating layer 236 may be omitted, and the channel layer 234 may be formed in a pillar shape for filling the residual portion of the channel hole 230H.

The gate electrode 222 may include metal such as tungsten, nickel, cobalt, tantalum or the like, conductive metal nitride such as titanium nitride, tantalum nitride, or tungsten nitride, a metal silicide such as tungsten silicide, nickel silicide, cobalt silicide, or tantalum silicide, doped polysilicon, or a combination thereof. A dielectric liner 249 may be arranged between the gate electrode 222 and the insulating layer 224, and the dielectric liner 249 may include a high dielectric constant material such as aluminum oxide.

The gate insulating layer 232 may have a structure sequentially including a tunneling dielectric layer 232A, a charge storing layer 232B, and a blocking dielectric layer 232C on an outer sidewall of the channel layer 234. The relative thicknesses of the tunneling dielectric layer 232A, the charge storing layer 232B, and the blocking dielectric layer 232C that constitute the gate insulating layer 232 are not limited to the illustration of FIGS. 8A through 8C and may be variously modified.

The tunneling dielectric layer 232A may include silicon oxide, hafnium oxide, aluminum oxide, zirconium oxide, tantalum oxide, and the like. The charge storing layer 232B that is an area in which electrons passing through the tunneling dielectric layer 232A from the channel layer 234 may be stored, may include silicon nitride, boron nitride, silicon boron nitride, or polysilicon doped with impurities. The blocking dielectric layer 232C may include metal oxide having a higher dielectric constant than a dielectric constant of silicon nitride, or silicon oxide. The metal oxide may include hafnium oxide, aluminum oxide, zirconium oxide, tantalum oxide, or a combination thereof.

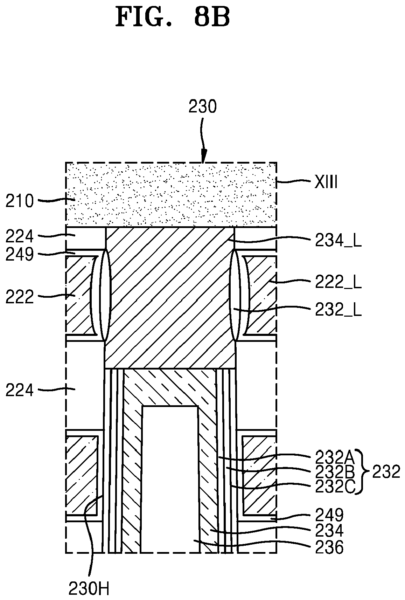

Referring to FIG. 8B, the cell channel structure 230 may further include a contact semiconductor layer 234_L and a bottom insulating layer 232_L, which are arranged at the bottom of the channel hole 230H (where a first end adjacent to the common source line layer 210 of the channel hole 230H is referred to as a bottom). The channel layer 234 may not come into direct contact with the common source line layer 210, and the channel layer 234 may be electrically connected to the common source line layer 210 through the contact semiconductor layer 234_L. In example embodiments, the contact semiconductor layer 234_L may include a silicon layer formed through a selective epitaxy growth (SEG) process in which the common source line layer 210 arranged at the bottom of the channel hole 230H is used as a seed layer.

The bottom insulating layer 232_L may be arranged between an uppermost gate electrode 222_L and a contact semiconductor layer 234_L arranged to be closest to the common source line layer 210. In example embodiments, the bottom insulating layer 232_L may include silicon oxide, and for example, the bottom insulating layer 232_L may be formed by performing an oxidation process on a portion of the sidewall of the contact semiconductor layer 234_L.

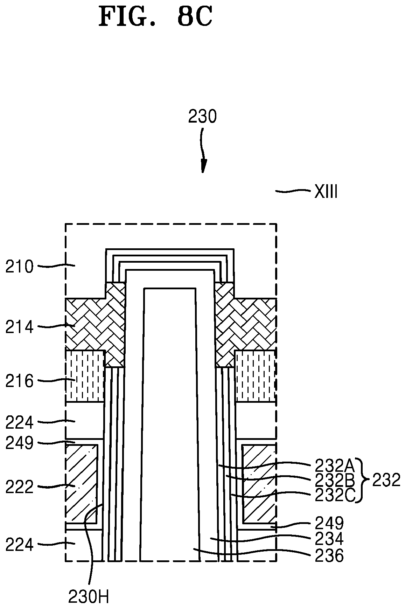

Referring to FIG. 8C, the cell channel structure 230 may have a structure in which the cell channel structure 230 is electrically connected to the horizontal semiconductor layer 214 through the sidewall of the channel layer 234 instead of being electrically connected to the common source line layer 210. For example, a horizontal semiconductor layer 214 and a support layer 216 may be sequentially stacked on the top surface of the common source line layer 210, and a cell stack 220 including an insulating layer 224 and a gate electrode 222 may be arranged on the support layer 216.

In example embodiments, the horizontal semiconductor layer 214 may include polysilicon doped with impurities or undoped polysilicon. The horizontal semiconductor layer 214 may function as a portion of a common source area for connecting the common source line layer 210 to the channel layer 234. For example, the support layer 216 may include doped or undoped polysilicon. The support layer 216 may function as a support layer for preventing collapse or fall of a mold stack in a process of removing a sacrificial material layer (not shown) for forming the horizontal semiconductor layer 214.

The gate insulating layer 232 may be arranged on an inner wall and the bottom of the channel hole 230H. The bottom surface of the channel layer 234 may be arranged on the gate insulating layer 232 and may not come into direct contact with the common source line layer 210, and the sidewall of the bottom of the channel layer 234 may be surrounded by the horizontal semiconductor layer 214.

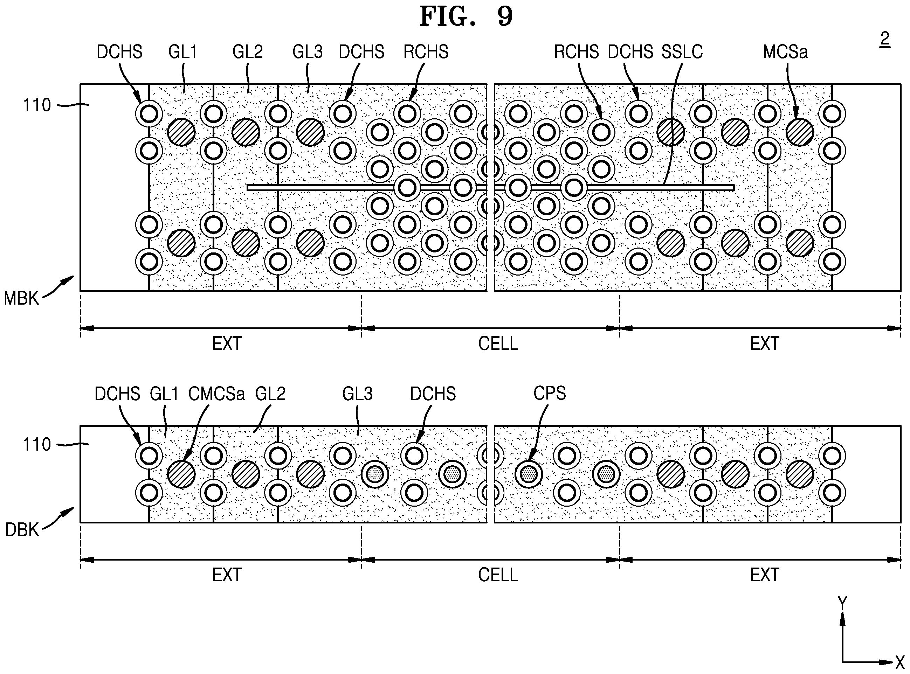

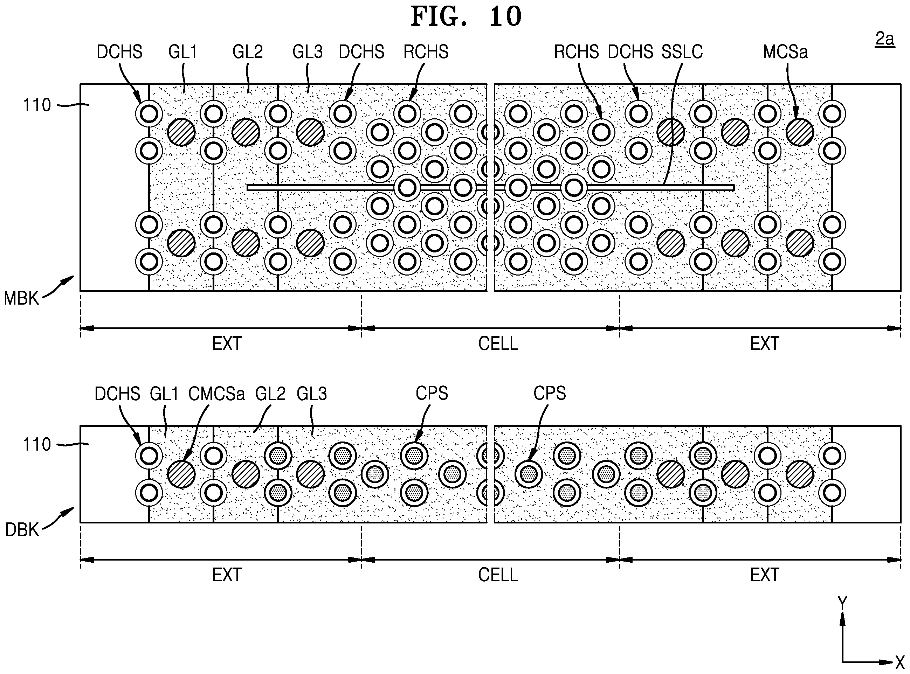

FIGS. 9 and 10 are plan views of a nonvolatile memory device according to embodiments. Referring to FIG. 9, a nonvolatile memory device 2 may have a plurality of cell contact structures MCSa and a plurality of capacitor gate contact structures CMCSa instead of the plurality of cell contact structures MCS and the plurality of capacitor gate contact structures CMCS of the nonvolatile memory device 1 shown in FIG. 5A. In some embodiments, the cell contact structure MCSa and the capacitor gate contact structure CMCSa may have substantially the same as or similar structure and shape.

Each of the plurality of cell contact structures MCSa and the plurality of capacitor gate contact structures CMCSa may be connected to one gate electrode of the plurality of gate electrodes GL1, GL2, and GL3. For example, the plurality of cell contact structures MCSa arranged in the connection area EXT of the main cell block MBK, and the plurality of capacitor gate contact structures CMCSa arranged in the connection area EXT of the dummy cell block DBK may be connected to a staircase-shaped tread portion of one gate electrode of the plurality of gate electrodes GL1, GL2 and GL3.

Referring to FIG. 10, a nonvolatile memory device 2a may have a plurality of cell contact structures MCSa and a plurality of capacitor gate contact structures CMCSa instead of the plurality of cell contact structures MCS and the plurality of capacitor gate contact structures CMCS of the nonvolatile memory device 1a shown in FIG. 6.

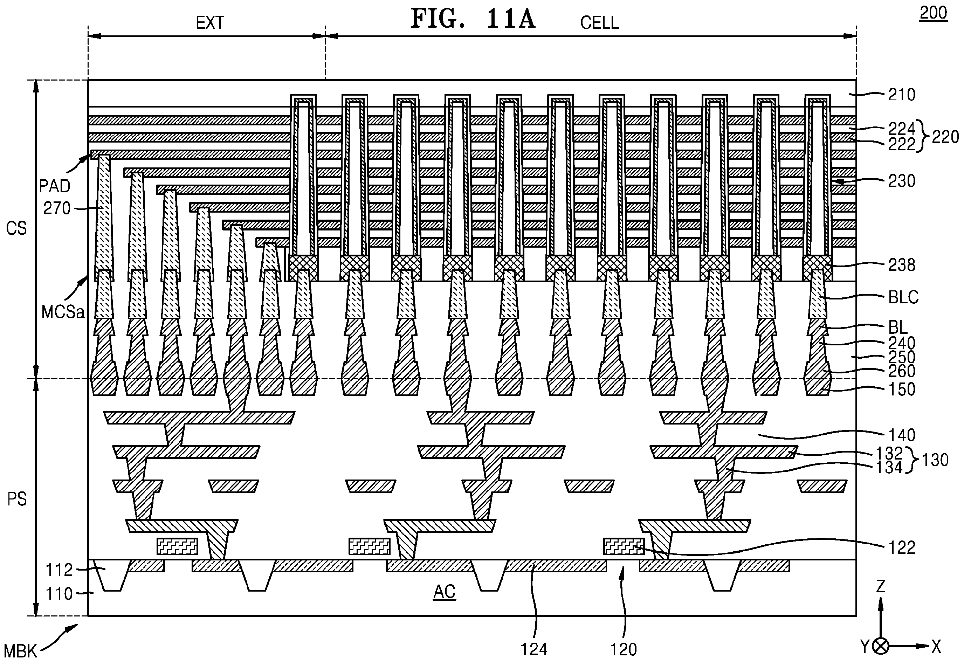

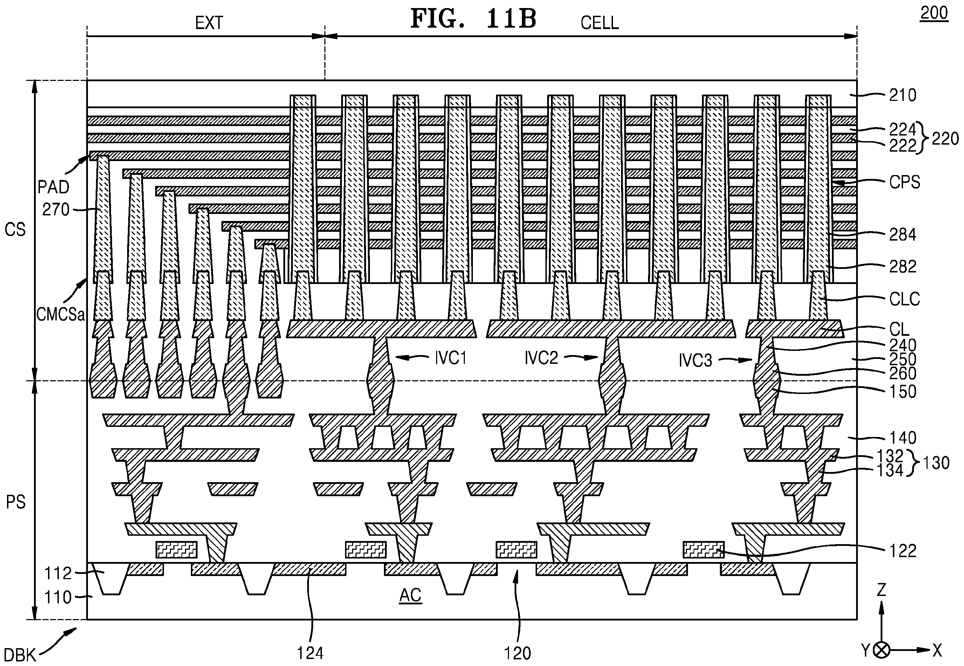

FIGS. 11A and 11B are cross-sectional views of a nonvolatile memory device according to embodiments. Referring to FIGS. 11A and 11B together, a nonvolatile memory device 200 may have a plurality of cell contact structures MCSa and a plurality of capacitor gate contact structures CMCSa instead of the plurality of cell contact structures MCS and the plurality of capacitor gate contact structures CMCS of the nonvolatile memory device 100 shown in FIGS. 7A and 7B.

A plurality of cell contact structures MCSa may be arranged in the connection area EXT of the main cell block MBK, may pass through the second insulating structure 250 and may be connected to the gate electrodes 222. A plurality of capacitor gate contact structures CMCSa may be arranged in the connection area EXT of the dummy cell block DBK, may pass through the second insulating structure 250 and may be connected to the gate electrode 222. A bit line contact BLC and a bit line BL connected to the bit line contact BLC may be arranged on each of the plurality of cell contact structures MCSa and the plurality of capacitor gate contact structures CMCSa, and the bit line BL may be connected to the second interconnect structure 240.

Each of the plurality of cell contact structures MCSa and the plurality of capacitor gate contact structures CMCSa may be connected to one gate electrode of the plurality of gate electrodes GL1, GL2, and GL3. For example, the plurality of cell contact structures MCSa arranged in the connection area EXT of the main cell block MBK, and the plurality of capacitor gate contact structures CMCSa arranged in the connection area EXT of the dummy cell block DBK may be connected to a staircase-shaped tread portion of the plurality of gate electrodes 222. In some embodiments, the plurality of cell contact structures MCSa arranged in the connection area EXT of the main cell block MBK, and the plurality of capacitor gate contact structures CMCSa arranged in the connection area EXT of the dummy cell block DBK may extend into the pad portion PAD of the plurality of gate electrodes 222.

In some embodiments, the cell contact structure MCSa and the capacitor gate contact structure CMCSa may have substantially the same or similar structures and shapes. For example, each of the plurality of cell contact structures MCSa and the plurality of capacitor gate contact structures CMCSa may include a conductive via 270. The conductive via 270 may pass through the second insulating structure 250 and may electrically connect the bit line contact BLC to one gate electrode 222 of the plurality of gate electrodes 222. The conductive via 270 may include a material that is the same as or similar to a material for forming the second interconnect structure 240.

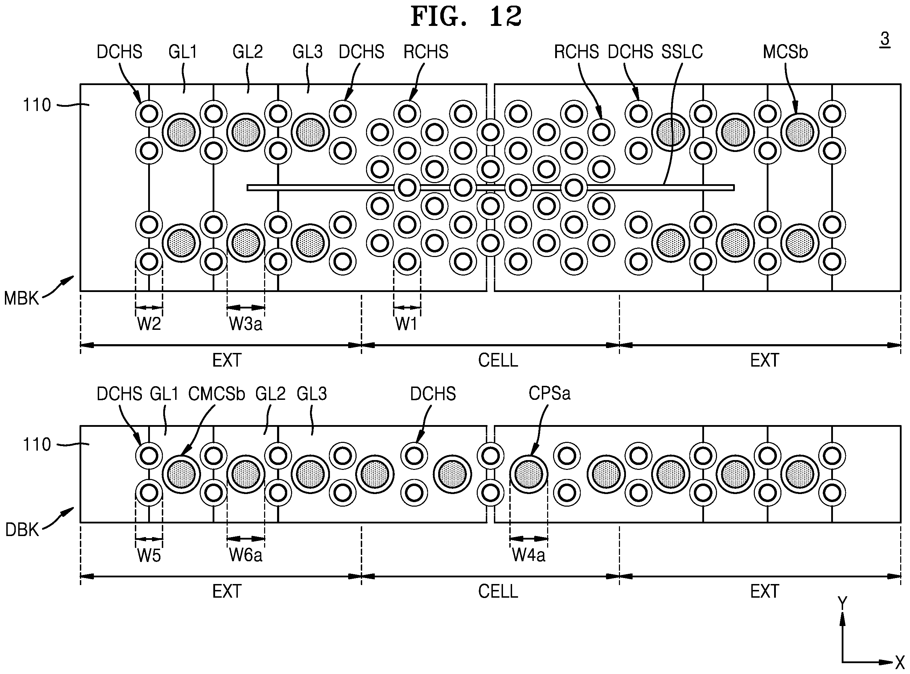

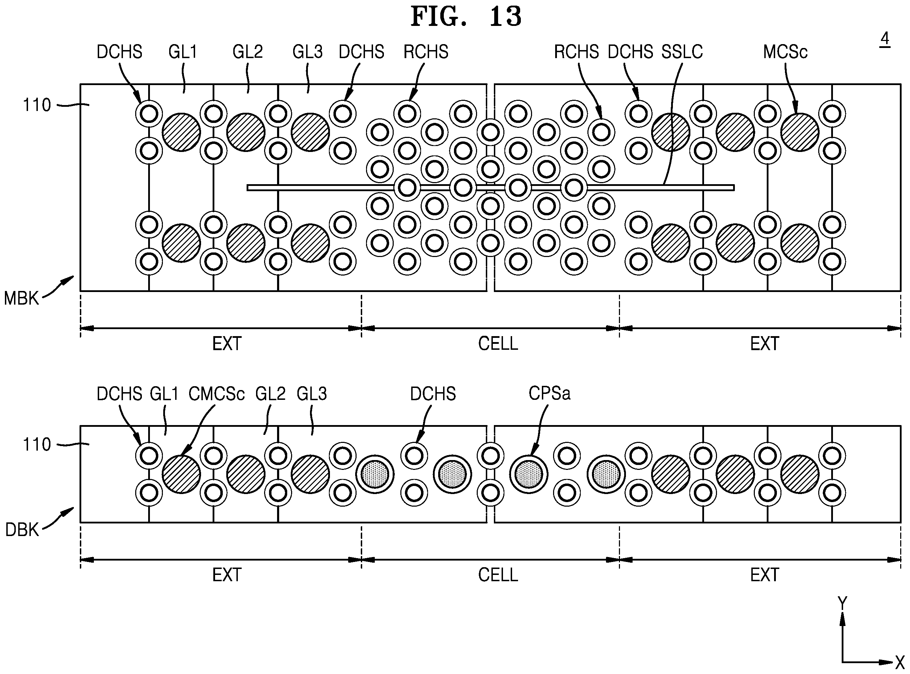

FIGS. 12 and 13 are plan views of a nonvolatile memory device according to embodiments. Referring to FIG. 12, a nonvolatile memory device 3 may have a plurality of cell contact structures MCSb, a plurality of capacitor core contact structures CPSa, and a plurality of capacitor gate contact structures CMCSb instead of the plurality of cell contact structures MCS, the plurality of capacitor core contact structures CPS, and the plurality of capacitor gate contact structures CMCS of the nonvolatile memory device 1 shown in FIG. 5A. In some embodiments, the plurality of cell contact structures MCSb, the plurality of capacitor core contact structures CPSa, and the plurality of capacitor gate contact structures CMCSb may have substantially the same or similar structures and shapes.

In the main cell block MBK, each of the plurality of cell channel structures RCHS may have a first horizontal width W1, and each of the plurality of dummy channel structures DCHS may have a second horizontal width W2, and each of the plurality of cell contact structures MCSb may have a third horizontal width W3a. In the dummy cell block DBK, each of the plurality of capacitor core contact structures CPSa may have a fourth horizontal width W4a, and each of the plurality of dummy channel structures DCHS may have a fifth horizontal width W5, and each of the plurality of capacitor gate contact structures CMCSb may have a sixth horizontal width W6a.

In some embodiments, the first horizontal width W1 and the second horizontal width W2 may have the same value. In the main cell block MBK, the plurality of cell channel structures RCHS and the plurality of dummy channel structures DCHS may have the same horizontal width. In some embodiments, the second horizontal width W2 and the fifth horizontal width W5 may have the same value. The plurality of dummy channel structures DCHS may have the same horizontal width in the main cell block MBK and the dummy cell block DBK.

In some embodiments, a third horizontal width W3a and a sixth horizontal width W6a may have the same value. The plurality of cell contact structures MCSb and the plurality of capacitor gate contact structures CMCSb may have the same horizontal width. In some embodiments, a fourth horizontal width W4a and a sixth horizontal width W6a may have the same value. The plurality of capacitor core contact structures CPSa and the plurality of capacitor gate contact structures CMCSb may have the same horizontal width.

In some embodiments, each of the third horizontal width W3a, the fourth horizontal width W4a, and the sixth horizontal width W6a may have the same value, and each of the first horizontal width W1, the second horizontal width W2, and the fifth horizontal width W5 may have the same value. In some embodiments, the third horizontal width W3a, the fourth horizontal width W4a, and the sixth horizontal width W6a may have greater values than those of the first horizontal width W1, the second horizontal width W2, and the fifth horizontal width W5.

In some embodiments, each of the cell contact structure MCSb, the capacitor core contact structure CPSa, and the capacitor gate contact structure CMCSb may have substantially the same or similar structure and shape as each of the cell contact structure MCS, the capacitor core contact structure CPS, and the capacitor gate contact structure CMCS shown in FIGS. 7A and 7B, excluding the horizontal widths.

Referring to FIG. 13, a nonvolatile memory device 4 may have a plurality of cell contact structures MCSc and a plurality of capacitor gate contact structures CMCSc instead of the plurality of cell contact structures MCSb and the plurality of capacitor gate contact structures CMCSb of the nonvolatile memory device 3 shown in FIG. 12. Because each of the cell contact structure MCSc and the capacitor gate contact structure CMCSc has substantially the same or similar structure and shape as each of the cell contact structure MCSa and the capacitor gate contact structure CMCSa and the horizontal widths shown in FIGS. 11A and 11B, excluding the horizontal widths, a detailed description thereof is omitted.

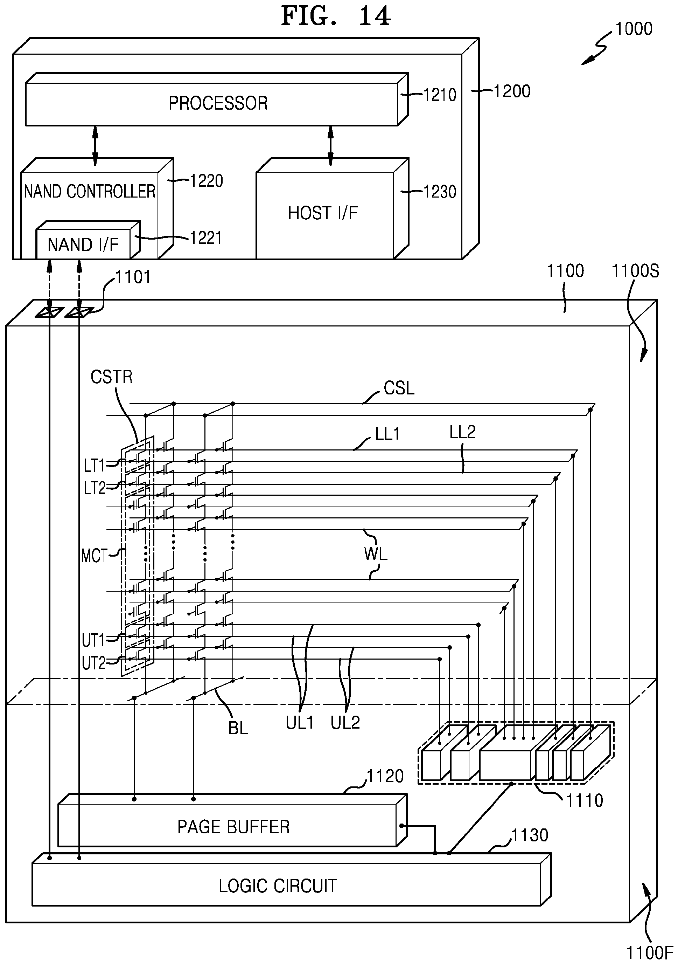

FIG. 14 is a view schematically illustrating a memory system of a nonvolatile memory device according to embodiments. Referring to FIG. 14, a memory system 1000 may include one or more memory devices 1100, and a memory controller 1200 electrically connected to the memory devices 1100. The memory system 1000 may be, for example, a solid state drive (SSD) device, a universal serial bus (USB), a computing system, a medical device, or a communication device including at least one memory device 1100.

The memory device 1100 may be a nonvolatile memory device. For example, the memory device 1100 may be one of the nonvolatile memory devices 1, 1a, 100, 2, 2a, 200, 3, and 4 described with reference to FIGS. 5A through 13, or a NAND flash memory device including a combination thereof. The memory device 1100 may include a first structure 1100F, and a second structure 1100S on the first structure 1100F. The first structure 1100F may correspond to the peripheral circuit structure PS shown in FIGS. 2, 7A, 7B, 11A, and 11B. The peripheral circuit 120 shown in FIGS. 7A, 7B, 11A, and 11B may include a row decoder 1110, a page buffer 1120, and a logic circuit 1130.

The second structure 1100S may correspond to the cell array structure CS shown in FIGS. 2, 7A, 7B, 11A, and 11B. The second structure 1100S may include a bit line BL, a common source line CSL, a plurality of word lines WL, first and second string selection lines UL1 and UL2, first and second ground selection lines LL1 and LL2, and a plurality of memory cell strings CSTR between the bit line BL and the common source line CSL. The plurality of cell channel structures 230 and the plurality of gate electrodes 222 shown in FIGS. 7A, 7B, 11A, and 11B may form a plurality of memory cell strings CSTR.

In the second structure 1100S, the plurality of memory cell strings CSTR may include ground selection transistors LT1 and LT2 each being adjacent to the common source line CSL, the string selection transistors UT1 and UT2 adjacent to the bit line BL, and a plurality of memory cell transistors MCT arranged between the ground selection transistors LT1 and LT2 and the string selection transistors UT1 and UT2. The number of ground selection transistors LT1 and LT2 and the number of string selection transistors UT1 and UT2 may be variously modified according to embodiments. One of the plurality of cell channel structures 230 shown in FIGS. 7A, 7B, 11A, and 11B and one of the plurality of gate electrodes 222 may form one of the plurality of transistors LT1, LT2, UT1, UT2, and MCT.

In example embodiments, each of the plurality of ground selection lines LL1 and LL2 may be connected to the gate electrodes of the ground selection transistors LT1 and LT2. The word line WL may be connected to the gate electrode of the memory cell transistor MCT. The plurality of string selection lines UL1 and UL2 may be connected to the gate electrodes of the string selection transistors UT1 and UT2, respectively.

The common source line CSL, the plurality of ground selection lines LL1 and LL2, the plurality of word lines WL, and the plurality of string selection lines UL1 and UL2 may be connected to the row decoder 1110. The plurality of bit lines BL may be electrically connected to a page buffer 1120.

The memory device 1100 may communicate with the memory controller 1200 through an external connection pad 1101 electrically connected to the logic circuit 1130. The external connection pad 1101 may be electrically connected to the logic circuit 1130. The memory controller 1200 may include a processor 1210, a NAND controller 1220, and a host interface 1230. In some embodiments, the memory system 1000 may include a plurality of memory devices 1100. In this case, the memory controller 1200 may control the plurality of memory devices 1100.

The processor 1210 may control an overall operation of the memory system 1000 including the memory controller 1200. The processor 1210 may operate according to a certain firmware, may control the NAND controller 1220 and may access the memory device 1100. The NAND controller 1220 may include a NAND interface 1221 for processing communication with the memory device 1100. Through the NAND interface 1221, a control command for controlling the memory device 1100, data to be written in a plurality of memory cell transistors MCT of the memory device 1100, and data to be read from a plurality of memory cell transistors MCT of the memory device 1100 may be transmitted. The host interface 1230 may provide a communication function between the memory system 1000 and the external host. When the control command is received from the external host through the host interface 1230, the processor 1210 may control the memory device 1100 in response to the control command.

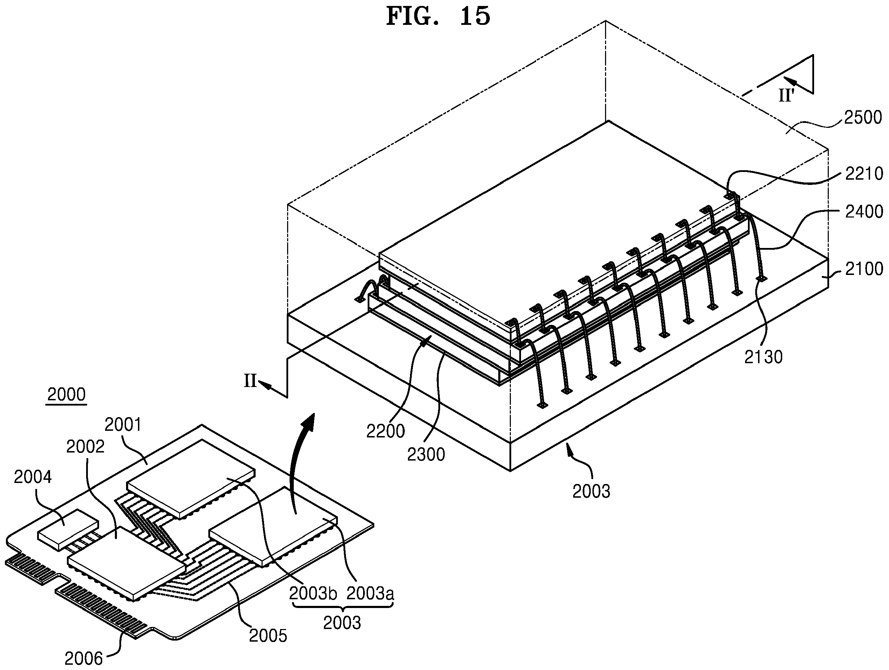

FIG. 15 is a perspective view schematically illustrating a memory system of a nonvolatile memory device according to embodiments. Referring to FIG. 15, a memory system 2000 according to an example embodiment may include a main substrate 2001, a memory controller 2002 mounted on the main substrate 2001, one or more semiconductor packages 2003, and a DRAM 2004. The semiconductor package 2003 and the DRAM 2004 may be connected to the memory controller 2002 by a plurality of wiring patterns 2005 formed on the main substrate 2001.

The main substrate 2001 may include a connector 2006 including a plurality of pins coupled to the external host. In the connector 2006, the number and arrangement of the plurality of pins may be changed according to the communication interface between the memory system 2000 and the external host. In some embodiments, the memory system 2000 may communicate with the external host according to one of interfaces such as an USB, a peripheral component interconnect express (PCI-Express), serial advanced technology attachment (SATA), M-Phy for universal flash storage (UFS), and the like. In some embodiments, the memory system 2000 may operate by power supplied from the external host through the connector 2006. The memory system 2000 may further include a power management integrated circuit (PMIC) in which power supplied from the external host is distributed to the memory controller 2002 and the semiconductor package 2003.

The memory controller 2002 may write data in the semiconductor package 2003 or may read data from the semiconductor package 2003 and may enhance the operation speed of the memory system 2000. The DRAM 2004 may be a buffer memory as a data storage space for buffering a speed difference between the semiconductor package 2003 and the external host. The DRAM 2004 included in the memory system 2000 may operate as a kind of cache memory and may provide a space for temporarily storing data in a control operation of the semiconductor package 2003. When the DRAM 2004 is included in the memory system 2000, the memory controller 2002 may further include a DRAM controller for controlling the DRAM 2004 except for the NAND controller for controlling the semiconductor package 2003.

The semiconductor package 2003 may include first and second semiconductor packages 2003a and 2003b, which are spaced apart from each other. The first and second semiconductor packages 2003a and 2003b may be semiconductor packages each including a plurality of semiconductor chips 2200. Each of the first and second semiconductor packages 2003a and 2003b may include a package substrate 2100, a plurality of semiconductor chips 2200 on the package substrate 2100, an adhesive layer 2300 arranged on the bottom surface of each of the plurality of semiconductor chips 2200, a connection structure 2400 for electrically connecting the plurality of semiconductor chips 2200 to the package substrate 2100, and a molding layer 2500 for covering the plurality of semiconductor chips 2200 and the connection structure 2400 on the package substrate 2100.

The package substrate 2100 may be a printed circuit board including a plurality of package upper pads 2130. Each of the plurality of semiconductor chips 2200 may include an input/output pad 2210. Each of the plurality of semiconductor chips 2200 may include at least one of the nonvolatile memory devices 1, 1a, 100, 2, 2a, 200, 3, and 4 described with reference to FIGS. 5A through 13.

In example embodiments, the connection structure 2400 may be a bonding wire for electrically connecting the input/output pad 2210 to the package upper pad 2130. Thus, in the first and second semiconductor packages 2003a and 2003b, the plurality of semiconductor chips 2200 may be electrically connected to each other in a bonding wire manner and may be electrically connected to the package upper pad 2130 of the package substrate 2100. In example embodiments, in the first and second semiconductor packages 2003a and 2003b, the plurality of semiconductor chips 2200 may be electrically connected to each other by a connection structure including a through silicon via (TSV) instead of the connection structure 2400 in the bonding wire manner.

In example embodiments, the memory controller 2002 and the plurality of semiconductor chips 2200 may be included in one package. In an example embodiment, the memory controller 2002 and the plurality of semiconductor chips 2200 may be mounted on a separate interposer substrate different from the main substrate 2001, and the memory controller 2002 and the plurality of semiconductor chips 2200 may be connected to each other by a wiring formed on the interposer substrate.

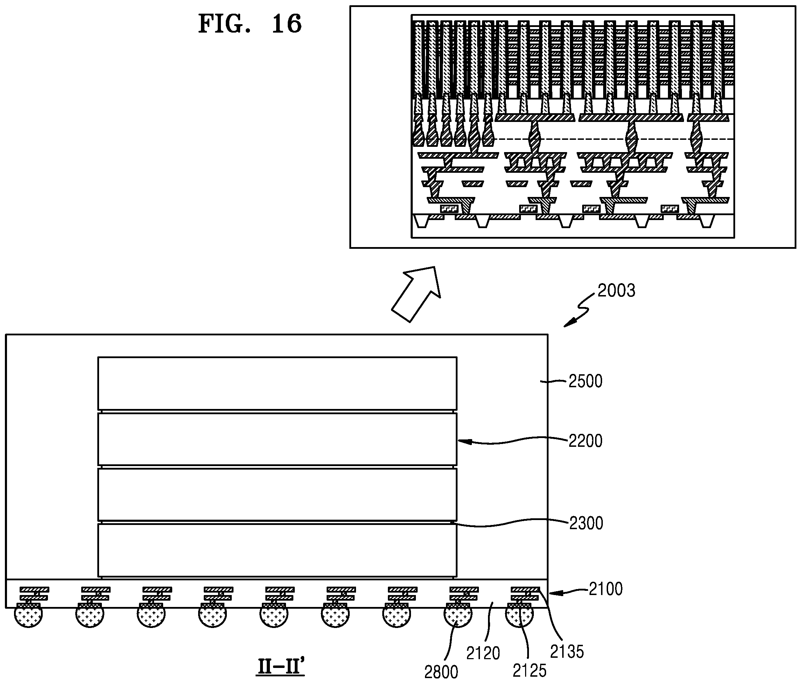

FIG. 16 is a cross-sectional view schematically illustrating a semiconductor package according to embodiments. Referring to FIG. 16, in the semiconductor package 2003, the package substrate 2100 may be a printed circuit board. The package substrate 2100 may include a package substrate body portion 2120, a plurality of package upper pads (see 2130 of FIG. 15) arranged on the top surface of the package substrate body portion 2120, a plurality of lower pads 2125 arranged on the bottom surface of the package substrate body portion 2120 or exposed through the bottom surface of the package substrate body portion 2120, and a plurality of internal wirings 2135 for electrically connecting the plurality of package upper pads (see 2130 of FIG. 15) and the plurality of lower pads 2125 inside the package substrate body portion 2120. As shown in FIG. 15, the plurality of package upper pads 2130 may be electrically connected to the plurality of connection structures 2400. The plurality of lower pads 2125 may be connected to the plurality of wiring patterns 2005 on the main substrate 2001 of the memory system 2000 shown in FIG. 15 through a plurality of conductive bumps 2800. Each of the plurality of semiconductor chips 2200 may include at least one of the nonvolatile memory devices 1, 1a, 100, 2, 2a, 200, 3, and 4 described with reference to FIGS. 5A through 13.

While the inventive concept has been particularly shown and described with reference to embodiments thereof, it will be understood that various changes in form and details may be made therein without departing from the scope of the following claims.

## Claims

1. A nonvolatile memory device, comprising:
a peripheral circuit structure comprising a peripheral circuit; and
a cell array structure bonded to the peripheral circuit structure, the cell array structure having a cell area and a connection area, and comprising:
a cell stack comprising a plurality of gate electrodes and a plurality of insulating layers alternately stacked, in the connection area, said plurality of gate electrodes having a staircase shape, a plurality of capacitor core contact structures configured to pass through the cell stack in the cell area, and a plurality of capacitor gate contact structures connected to the plurality of gate electrodes in the connection area; and
wherein each of the plurality of capacitor core contact structures includes: (i) a first core conductor electrically connected to the peripheral circuit, and (ii) a first cover insulating layer extending between the first core conductor and the plurality of gate electrodes, and constitutes a capacitor in which the first core conductor, the first cover insulating layer, and the plurality of gate electrodes are connected to the peripheral circuit, and at least a portion of the plurality of capacitor core contact structures overlaps the peripheral circuit electrically connected to the plurality of capacitor core contact structures in a vertical direction.

2. The device of claim 1,
wherein the cell array structure further comprises a plurality of capacitor line patterns electrically connected to the first core conductor of the plurality of capacitor core contact structures;
wherein the plurality of capacitor core contact structures include a first capacitor core contact structure group, and a second capacitor core contact structure group, as different portions of the plurality of capacitor core contact structures; and
wherein the plurality of capacitor line patterns include a first capacitor line pattern and a second capacitor line pattern, which: (i) electrically connect to the first capacitor core contact structure group and the second capacitor core contact structure group, respectively (ii) are spaced apart from each other, and (iii) are insulated from each other.

3. The device of claim 2,
wherein the number of capacitor core contact structures of the first capacitor core contact structure group is greater than the number of capacitor core contact structures of the second capacitor core contact structure group; and
wherein a greater power than a power provided by a second power supply connected to the first core conductor of the capacitor core contact structure of the second capacitor core contact structure group is provided by a first power supply, which is connected to the first core conductor of the capacitor core contact structure of the first capacitor core contact structure group.

4. The device of any preceding claim, wherein each of the plurality of capacitor gate contact structures passes through the cell stack in the connection area and comprises a second core conductor, a second cover insulating layer located between the second core conductor and the plurality of gate electrodes, and a connection conductor configured to pass through the second cover insulating layer and electrically connect the second core conductor to one of the plurality of gate electrodes.

5. The device of any preceding claim, wherein each of the plurality of capacitor gate contact structures comprises a conductive via and is connected to a staircase-shaped tread portion of the plurality of gate electrodes.

6. The device of any preceding claim, wherein the cell array structure further comprises:
a plurality of dummy channel structures arranged in at least one area of the connection area and configured to pass through the cell stack;
wherein in the cell area, the plurality of dummy channel structures are spaced apart from the plurality of capacitor core contact structures; and
wherein each of the plurality of capacitor core contact structures is surrounded by portions of the plurality of dummy channel structures.

7. The device of any preceding claim, wherein the plurality of capacitor core contact structures are arranged in a honeycomb shape such that the plurality of capacitor core contact structures are arranged in a zigzag manner with respect to a horizontal direction.

8. A nonvolatile memory device, comprising:
a peripheral circuit structure comprising a peripheral circuit; and
a cell array structure bonded to the peripheral circuit structure, the cell array structure comprising:
a main cell block and a dummy cell block each including a cell area and a connection area;
a cell stack comprising a plurality of gate electrodes and a plurality of insulating layers alternately stacked, wherein the plurality of gate electrodes have a staircase shape in the connection area;
a plurality of cell channel structures configured to pass through the cell stack in the cell area of the main cell block;
a plurality of capacitor core contact structures configured to pass through the cell stack in the cell area of the dummy cell block; and
a plurality of capacitor gate contact structures connected to the plurality of gate electrodes in the connection area of the dummy cell block; and
wherein each of the plurality of capacitor core contact structures includes a first core conductor electrically connected to the peripheral circuit, and a first cover insulating layer extending between the first core conductor and the plurality of gate electrodes, and constitutes a capacitor in which the first core conductor, the first cover insulating layer, and the plurality of gate electrodes are connected to the peripheral circuit.

9. The device of claim 8, wherein the cell array structure comprises:
a plurality of bit lines electrically connected to the plurality of cell channel structures; and
a plurality of capacitor line patterns electrically connected to the first core conductor of the plurality of capacitor core contact structures and at a same vertical level as a level of the plurality of bit lines.

10. The device of claim 9,
wherein the plurality of capacitor core contact structures include a first capacitor core contact structure group, and a second capacitor core contact structure group each including different portions of the plurality of capacitor core contact structures; and
wherein the plurality of capacitor line patterns include a first capacitor line pattern and a second capacitor line pattern, which electrically connect to the first capacitor core contact structure group and the second capacitor core contact structure group respectively, are spaced apart from each other, and are insulated from each other.

11. The device of claim 10,
wherein the number of capacitor core contact structures of the first capacitor core contact structure group is greater than the number of capacitor core contact structures of the second capacitor core contact structure group; and
wherein a greater power than a power provided by a second power supply connected to the first core conductor of the capacitor core contact structure of the second capacitor core contact structure group is provided by a first power supply connected to the first core conductor of the capacitor core contact structure of the first capacitor core contact structure group.

12. The device of any one of claims 9 to 11, wherein an extension direction of at least a portion of the plurality of capacitor line patterns is different from an extension direction of the plurality of bit lines.

13. The device of any one of claims 8 to 12, wherein each of the plurality of capacitor gate contact structures is configured to pass through the cell stack in the connection area of the dummy cell block, and comprises a second core conductor, a second cover insulating layer located between the second core conductor and the plurality of gate electrodes, and a connection conductor configured to pass through the second cover insulating layer and electrically connect the second core conductor to one of the plurality of gate electrodes.

14. The device of any one of claims 8 to 13, wherein each of the plurality of capacitor gate contact structures comprises a conductive via and is connected to a staircase-shaped tread portion of the plurality of gate electrodes.

15. The device of any one of claims 8 to 14, wherein at least a portion of the plurality of capacitor core contact structures electrically connected to the peripheral circuit overlaps the peripheral circuit electrically connected to the capacitor core contact structure in a vertical direction.
